Europäisches Patentamt

European Patent Office

Office européen des brevets

(19)

(11) **EP 1 187 339 A1**

(12) **EUROPEAN PATENT APPLICATION**
published in accordance with Art. 158(3) EPC

(43) Date of publication:
**13.03.2002 Bulletin 2002/11**

(51) Int Cl.⁷: **H03M 13/27**

(21) Application number: **01912472.6**

(86) International application number:
**PCT/JP01/02146**

(22) Date of filing: **19.03.2001**

(87) International publication number:
**WO 01/69794 (20.09.2001 Gazette 2001/38)**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **17.03.2000 JP 2000076879**

(71) Applicant: **MATSUSHITA ELECTRIC INDUSTRIAL
CO., LTD.**
**Kadoma-shi, Osaka 571-8501 (JP)**

(72) Inventors:
• **IKEDA, Tetsuya**
  **Yokosuka-shi, Kanagawa 239-0847 (JP)**
• **SUZUKI, Hidetoshi**
  **Yokosuka-shi, Kanagawa 239-0847 (JP)**
• **YAMANAKA, Ryutaro**
  **Yokohama-shi Kanagawa 233-0001 (JP)**
• **KURIYAMA, Hajime**
  **Yokohama-shi Kanagawa 233-0001 (JP)**

(74) Representative: **Grünecker, Kinkeldey,
Stockmair & Schwanhäusser Anwaltssozietät
Maximilianstrasse 58
80538 München (DE)**

(54) **INTERLEAVE ADDRESS GENERATOR**

(57) Memory address generation apparatus 12 generates memory addresses, multiplier 15 reads from memory 14 storing row transposition patterns of a matrix a row transposition pattern value corresponding to the row number output from row counter 11 and calculates an address offset value by multiplying the transposition pattern value of the read row by the number of columns of the matrix, adder 16 reads from memory 13 storing row transposition patterns of the matrix a column transposition pattern value corresponding to the memory address generated by the memory address generation apparatus and generates an interleave address by adding up the transposition pattern value of the read column and the address offset value.

FIG. 7

EP 1 187 339 A1

**Description**

Technical Field

The present invention relates to an interleave address generation apparatus that makes it easier, through rearrangement of data, to correct burst errors that occur in a communication path, and more particularly, to an interleave address generation apparatus applicable to error correction using turbo codes.

Background Art

There is a move afoot to standardize third generation communication systems worldwide and use of prime interleaving for an interleaver/deinterleaver incorporated in a turbo coder/decoder has been proposed and standardized. Prime interleaving is one of ways of non-uniform interleaving (random interleaving) necessary to implement a turbo coder. In this prime interleaving, data is rearranged by writing data in memory in address sequence and reading this data written in memory in the sequence different from the sequence in which data is written. That is, in prime interleaving, data is written in memory sequentially starting from address 0, then memory addresses are rearranged and data is read in the rearranged address sequence. This is how interleaved data is obtained.

Here, terms that will be used in the explanations below are defined as follows:

"Column transposition pattern value" $c(i)$ $(i=1,2, \cdots)$ is an element of a "column transposition pattern" $c_0=\{c(i)\}$ expressed by a set.
"Shift coefficient" $q(j)$ $(j=1,2,\cdots)$ is an element of a shift coefficient set" $\{q(j)\}$ expressed by a set.
"New shift coefficient" $p(j)$ $(j=1,2,\cdots)$ is an element of a "new shift coefficient set" $\{p(j)\}$ expressed by a set.
"Row transposition pattern value" $P(j)$ $(j=1,2,\cdots)$ is an element of a "row transposition pattern" $\{P(j)\}$ expressed by a set.

When a set is expressed, curly brackets {} are used to distinguish a set from an element thereof.

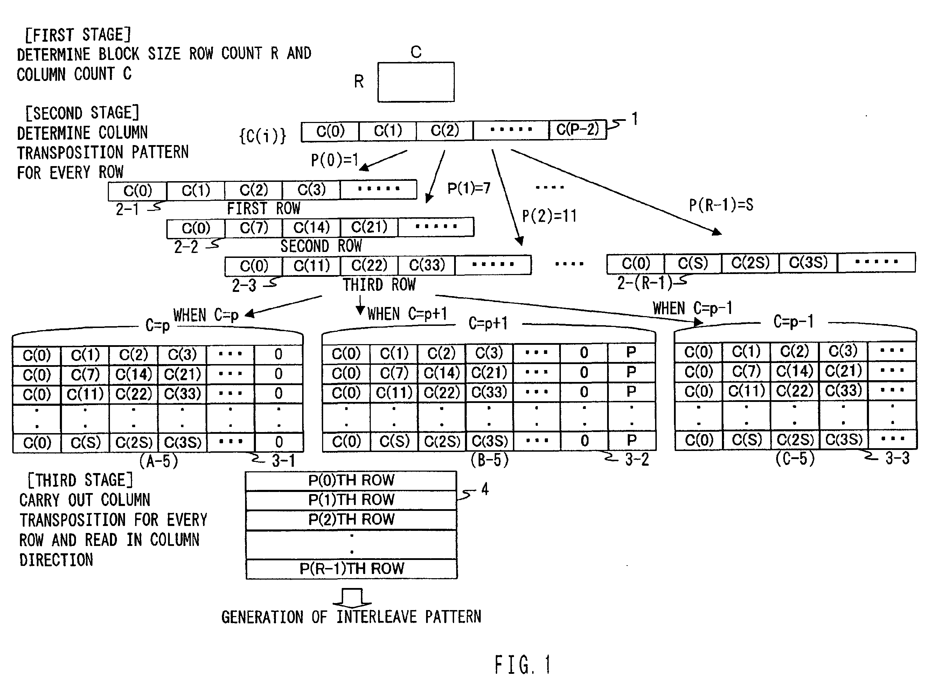

FIG.1 illustrates a method of generating interleave addresses and interleave patterns according to conventional prime interleaving. As shown in this figure, the method of generating prime interleave addresses has a three-stage configuration. This method will be explained sequentially focused on each stage.

(First stage)

In a first stage, the number of rows R and the number of columns C of a matrix to perform prime interleaving are determined. The number of rows R is determined according to the value of interleaving size K (K = 320 to 8192) under the following conditions.
R = 10 (K = 481 to 530)
R = 20 (K outside the range above)
The number of columns C is determined under the following conditions.

(1) When R = 10, C = 53
(2) When R = 20

① Minimum p which satisfies expression (1) and is a prime number at the same time is found.

$$0 \leq (p+1)\text{-}K/R \qquad (1)$$

② The calculation shown in expression (2) is performed using p found in ①.

$$\text{if } (0 \leq p\text{-}K/R) \text{ then go to ③ else } C = p+1 \qquad (2)$$

③ The calculation shown in expression (3) is performed according to the calculation result in ②.

$$\text{if } (0 \leq p\text{-}1\text{-}K/R) \text{ then } C = p\text{-}1 \text{ else } C = p \qquad (3)$$

In this way, the number of rows R and number of columns C are determined to perform prime interleaving.

(Second stage)

In a second stage, a column transposition pattern is calculated for every row to transpose address columns . The column transposition pattern for every row varies slightly depending on which value of C=p, C=p+1 and C=p-1 is the number of columns C calculated in the first stage. A method of calculating column transposition patterns will be explained separately in respective cases of C=p, C=p+1 or C=p-1.

In FIG.1, pattern 1 is a basic column transposition pattern $c_0=\{c(i)\}$, column pattern 2-1 is a transposition pattern $\{c_1(i)\}$ on the first row, column pattern 2-2 is a transposition pattern $\{c_2(i)\}$ on the second row, pattern 2-3 is a column transposition pattern $\{c_3(i)\}$ on the third row, and pattern 2-(R-1) is a column transposition pattern $\{c_{R-1}(i)\}$ on the (R-1)th row. Patterns 2-1 to 2-(R-1) are column transposition patterns when a "new shift coefficient set" is set to $\{p(j)\}=\{1,7,11,\cdots,s\}$.

On the other hand, patterns 3-1, 3-2 and 3-3 list column transposition patterns on their respective rows in the cases of C=p, C=p+1 and C=p-1, and pattern 4 gives a conceptual view of row transposition.

First, the method of calculating of a column transposition pattern on each row when C=p will be explained.

<A: when C=p>

(A-1)

First, a known primitive prime number $g_0$ is selected which has a one-to-one correspondence with minimum prime number p shown in Table 1 that satisfies expression (1).

Table 1

| P | $g_0$ | p | $g_0$ | p | $g_0$ | p | $g_0$ | p | $g_0$ | p | $g_0$ | p | $g_0$ | p | $g_0$ |
|---|---|---|---|---|---|---|---|---|---|---|---|---|---|---|---|
| 17 | 3 | 59 | 2 | 103 | 5 | 157 | 5 | 211 | 2 | 269 | 2 | 331 | 3 | 389 | 2 |
| 19 | 2 | 61 | 2 | 107 | 2 | 163 | 2 | 223 | 3 | 271 | 6 | 337 | 10 | 397 | 5 |
| 23 | 5 | 67 | 2 | 109 | 6 | 167 | 5 | 227 | 2 | 277 | 5 | 347 | 2 | 401 | 3 |
| 29 | 2 | 71 | 7 | 113 | 3 | 173 | 2 | 229 | 6 | 281 | 3 | 349 | 2 | 409 | 21 |
| 31 | 3 | 73 | 5 | 127 | 3 | 179 | 2 | 233 | 3 | 283 | 3 | 353 | 3 | | |
| 37 | 2 | 79 | 3 | 131 | 2 | 181 | 2 | 239 | 7 | 293 | 2 | 359 | 7 | | |
| 41 | 6 | 83 | 2 | 137 | 3 | 191 | 19 | 241 | 7 | 307 | 5 | 367 | 6 | | |
| 43 | 3 | 89 | 3 | 139 | 2 | 193 | 5 | 251 | 6 | 311 | 17 | 373 | 2 | | |
| 47 | 5 | 97 | 5 | 149 | 2 | 197 | 2 | 257 | 3 | 313 | 10 | 379 | 2 | | |
| 53 | 2 | 101 | 2 | 151 | 6 | 199 | 3 | 263 | 5 | 317 | 2 | 383 | 5 | | |

(A-2)

Then, the transposition pattern of the basic column $c_0=\{c(i)\}$ (i=1,2,$\cdots$,p-2, and c(0)=1) is calculated from expression (4):

$$c(i)=[g_0 \times c(i-1)]\bmod p, \quad i=1,2,\cdots(p-2), \text{ and } c(0)=1 \qquad (4)$$

From expression (4), the transposition pattern of the basic column is:

$$c_0=\{c(i)\}=\{c(0)=1,c(1),c(2),\cdots,c(p-2)\}$$

If, for example, $\{c(i)\}=\{2,3,1,0,4\}$, the address of original third column (i=0) is transposed to the address of the first column, the address of original fourth column (i=1) is transposed to the address of the second column, the address of original second column (i=2) is transposed to the address of the third column, the address of original first column (i=3) is transposed to the address of the fourth column, and the address of original fifth column (i=4) is transposed to the address of the fifth column.

(A-3)

Next, based on transposition pattern $c_0$ of the basic column, column transposition pattern $\{c_j(i)\}$ on each row is determined. To determine column transposition pattern $\{c_j(i)\}$ on each row, a shift coefficient set:

$$q_0=\{g(j)\}=\{q(0)=1,q(1),q(2),\cdots q(R-1)\}$$

is determined first. Shift coefficient set q(j) takes a value that satisfies following expressions (5) to (7):

$$g.c.d\{q(j),p-1\}=1 \tag{5}$$

$$q(j)>6 \tag{6}$$

$$q(j)>q(j-1) \qquad j=1,2,\cdots(R-1), \text{ and } q(0)=1 \tag{7}$$

where g.c.d denotes a greatest common divisor and shift coefficient q(j) is a prime number. Furthermore, suppose a shift coefficient about the first row is q(0)=1. For example, when R=5, $\{q(j)\}=\{1,7,11,13,17\}$.

(A-4)

Then, a new shift coefficient set $\{p(j)\}(j=0,1,\cdots R-1)$ is calculated. The new shift coefficient set $\{p(j)\}$ is calculated by converting shift coefficient set $\{q(j)\}$ according to pre-defined row transposition pattern $\{P(j)\}$ using expression (8).

$$q(P(j))=q(j) \tag{8}$$

For example, if $\{P(j)\}=\{4,1,0,3,2\}$ and $\{q(j)\}=\{1,7,11,13,17\}$, then the new shift coefficient set is $\{p(j)\}=\{13,7,17,11,1\}$.

(A-5)

Using basic column transposition pattern $c_0$ calculated from (A-2) and the new shift coefficient set $\{p(j)\}$ calculated from (A-4), the column transposition pattern $\{c_j(i)\}$ of the jth row (j=0,1,$\cdots$,R-1) is obtained from expression (9).

$$c_j(i)=c([i \times p(j)]mod(p-1), i=0,1,2,\cdots, (p-2), \text{ and}$$

$$c_j(p-1)=0 \tag{9}$$

For example, if $\{p(j)\}=\{1,7,11,\cdots,s\}$, the calculation result of expression (9) is as shown in patterns2-1 to 2-(R-1). Pattern 3-1 lists transposition patterns on their respective rows in this case.
Then, the method of calculating column transposition patterns on the respective rows when C=p+1 will be explained below.

<B: when C=p+1>

(B-1)

Processed in the same way as in the case of (A-1).

(B-2)

Processed in the same way as in the case of (A-2).

(B-3)

Processed in the same way as in the case of (A-3).

(B-4)

Processed in the same way as in the case of (A-4).

(B-5)

Using basic column transposition pattern $c_0$ calculated in (B-2) and shift coefficient set $\{p(i)\}$ calculated in (B-4), column transposition pattern $\{c_j(i)\}$ on the jth row (j=0,1,···,R-1) is calculated from expression (10).

$$c_j(i)=c([i \times p(j)]\bmod(p-1)),\ i=0,1,2,\cdots,(p-2),\ \text{and}$$

$$c_j(p-1)=0, c_j(p)=p \tag{10}$$

For example, if $\{p(j)\}=\{1,7,11,\cdots,s\}$, the calculation result of expression (10) is as shown in 2-1 to 2-(R-1). Pattern 3-2 lists transposition patterns on their respective rows in this case.

Next, the method of calculating column transposition patterns on their respective rows when C=p-1 will be explained.

<C: when C=p-1>

(C-1)

Processed in the same way as in the case of (A-1).

(C-2)

Processed in the same way as in the case of (A-2).

(C-3)

Processed in the same way as in the case of (A-3).

(C-4)

Processed in the same way as in the case of (A-4).

(C-5)

Using basic column transposition pattern $c_0$ calculated in (C-2) and shift coefficient set $\{p(i)\}$ calculated in (B-4), column transposition pattern $\{c_j(i)\}$ on the jth row (j=0,1,···,R-1) is calculated from expression (11).

$$c_j(i)=c([i \times p(j)]\bmod(p-1))-1,\ i=0,1,2,\cdots,(p-2) \tag{11}$$

For example, if $\{p(j)\}=\{1,7,11,\cdots,s\}$, the calculation result of expression (11) is as shown in 2-1 to 2-(R-1). Pattern 3-3 lists transposition patterns on their respective rows in this case.

Column transposition patterns are created as shown above. Addresses are rearranged in the column direction according to the transposition patterns created in this way.

(Third stage)

In a third stage, in order to transpose addresses in the row direction, rows are transposed as shown in pattern 4 according to predetermined row transposition pattern {P(j)}. For example, if {P(j)}={4,1,3,0,2}, the address of the (j=0) th row is transposed to the address of the 4th row.

As the respective row transposition patterns, the following three patterns are defined according to the number of rows R:

$P_A$:{19,9,14,4,0,2,5,7,12,18,10,8,13,17,3,1,16,6 ,15,11} for R=20
$P_B$:{19,9,14,4,0,2,5,1,12,18,16,13,17,15,3,1,6,1 1,8,10} for R=20
$P_C$:{9,8,7,6,5,4,3,2,1,0} for R=10

The transposition patterns of the respective rows are assigned for interleave size K as shown in Table 2.

Table 2

| Interleave size K | Row transposition pattern P($j$) |
|---|---|
| 320 to 480 | $P_A(j)$ |
| 481 to 530 | $P_C(j)$ |
| 531 to 2280 | $P_A(j)$ |
| 2281 to 2480 | $P_B(j)$ |
| 2481 to 3160 | $P_A(j)$ |
| 3161 to 3210 | $P_B(j)$ |
| 3211 to 8192 | $P_A(j)$ |

Row transposition patterns are created as shown above and addresses after column transpositions are further transposed according to the transposition patterns created. Interleave patterns are created in this way.

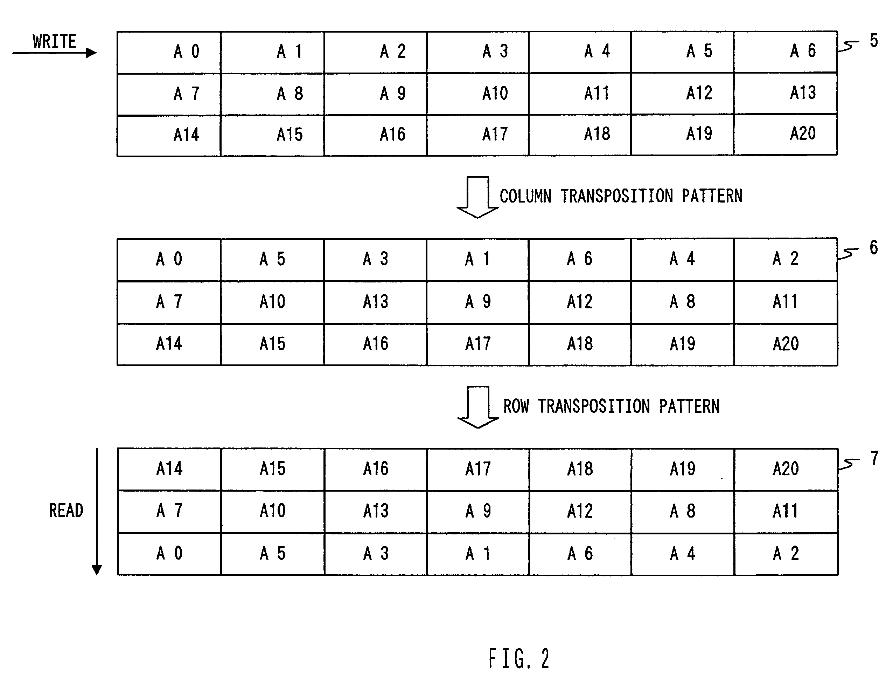

Then, data rearrangement using interleave patterns will be explained with reference to FIG.2. FIG.2 illustrates rearrangement of 21-bit data using interleave patterns. Here, suppose the column transposition pattern on the 1st row is {$c_0(i)$}={0,5,3,1,6,4,2}, the column transposition pattern on the 2nd row is {$c_1(i)$}=(0,3,6,2,5,1,4), the column transposition pattern on the 3rd row is {$c_2(i)$}={0,1,2,3,4,5,6}, and the row transposition pattern is {P(j)}={2,1,0}. Moreover, each block of the matrix is assigned addresses A0 to A20 as shown in address array 5.

First, as shown in address array 5, 21-bit data {0,1,2,3,4,5,6,7,8,9,10,11,12,13,14,15,16,17,18,19,2 0} is written in the row direction sequentially in memory in which addresses are allocated. That is, data #N (N=0 to 20) is written at address #N (N=0 to 20). More specifically, data A0 is written at address A0, data 1 is written at address A1, data 2 is written at address A2, and other data is written according to the same rule.

Then, addresses on each row shown in address array 5 are rearranged as shown in address array 6 according to column transposition patterns {$c_0(i)$}, {$c_1(i)$} and {$c_2(i)$}. Then, the transposed column data shown in address array 6 is rearranged as shown in address array 7 according to row transposition pattern {P(j)}.

Finally, when data is read in the column direction starting from row 1, column 1 according to the rearranged addresses as shown in address array 7, the data is read in order of A14, A7, A0, A15, A10, A5, A16, A13, A3, A17, A9, A1, A18, A12, A6, A19, A8, A4, A20, A11, and A2. In this case, since data corresponding to each address is read, the data read is {14,7,0,15,10,5,16,13,3,17,9,1,18,12,6,19,8,4,20,11, 2}. This is how data is rearranged using interleave patterns.

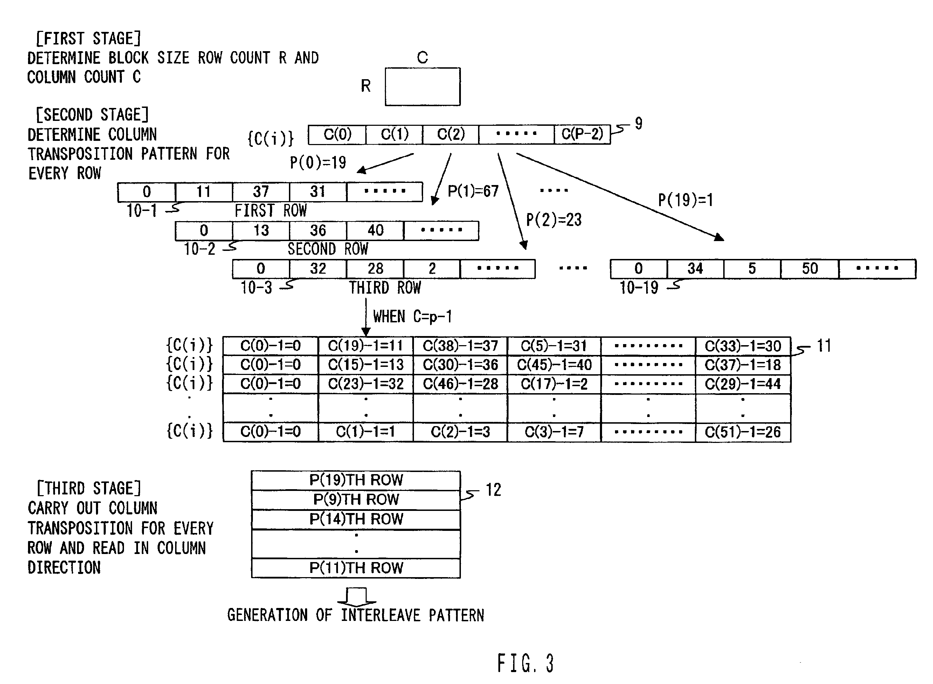

Then, the above-described interleave address generation method will be explained more specifically taking a case of K=1000 as an example with reference to FIG.3. FIG.3 illustrates the case where interleave size K=1000 of the prime interleave address generation method as an example.

In FIG.3, pattern 9 is a transposition pattern of the basic column, pattern 10-0 is a transposition pattern $c_0$= {c(i)} of the basic column, pattern 10-1 is a column transposition pattern {$c_1(i)$} on the 1st row, pattern 10-2 is a column transposition pattern {$c_2(i)$} on the 2nd row, pattern 10-3 is a column transposition pattern {$c_3(i)$} on the 3rd row, and pattern 10-19 is a column transposition pattern {$c_{19}(i)$} on the 19th row. Furthermore, pattern 11 lists column transposition patterns on their respective rows and pattern 12 shows a conceptual view of row transposition.

In a first stage, the number of rows R is determined first. When K=1000, R=20 according to the above condition. Then, the number of columns C is determined. When R=20 and K=1000 are substituted into expression (1),

$$0 \leqq (p+1)-1000/20$$

Since minimum p that satisfies this and at the same time is a prime number is 53, p=53 is determined. Then, when R=20, K=1000 and p=53 are substituted into expression (2),

$$p-K/R=53-1000/20=3 \geqq 0$$

Thus, the process moves on to expression (3). When R=20, K=1000 and p=53 are also substituted into expression (3),

$$p-1-K/R=53-1-1000/20=2 \geqq 0$$

Thus, C=p-1=52, and the number of columns is determined as 52 columns.

In this way, the number of rows R=20 and the number of columns C=p-1=52 of the matrix to carry out prime interleaving are determined.

In a second stage, a column transposition pattern is determined for every row.

First, when a transposition pattern of the basic column is calculated according to expression (4),

$$c_0=\{c(i)\}=\{c(0),c(1),c(2),\cdots,c(51)\}$$

$$=\{1,2,4,8,16,32,11,22,44,35,17,34,15,30,7,14,28$$

$$,3,6,12,24,48,43,33,13,26,52,51,49,45,37,21,42,31,9,$$

$$18,36,19,38,23,46,39,25,50,47,41,29,5,10,20,40,27\}$$

Since p=53, $g_0=2$ is assumed from Table 1.

Then, a shift coefficient set is calculated by expression (5) to expression (7):

$$\{q(j)\}=\{q(0),q(1),q(2),\cdots q(19)\}$$

$$=\{1,7,11,17,19,23,29,31,37,41,43,47,53,59,61,67$$

$$,71,73,79,83\}$$

Furthermore, from Table 2, the row transposition pattern when K=1000 is:

$$\{P(j)\}=\{19,9,14,4,0,2,5,7,12,18,10,8,13,17,3,1,$$

$$16,6,15,11\}$$

If these $\{q(j)\}$ and $\{P(j)\}$ are substituted into expression (8), new shift coefficient set $\{p(j)\}$ is:

$$\{p(j)\}=\{p(0),p(1),p(2),\cdots,p(19)\}$$

$$=$$

$$\{19,67,23,61,17,29,73,31,47,7,43,83,37,53,11,79,71,5\ 9,41,1\}$$

When this $\{p(j)\}$ and aforementioned $\{c(i)\}$ are substituted into expression (11), column transposition pattern $\{c_j(i)\}$ for every row is determined as shown in patterns 10-1 to 10-19. For example,

$$\{c_0(i)\}=\{0,11,37,31,\cdots,30\}$$

$$\{c_1(i)\}=\{0,13,36,40,\cdots,18\}$$

$$\{c_2(i)\}=\{0,32,28,2,\cdots,44\}$$

$$\{c_{19}(i)\}=\{0,1,3,7,\cdots,26\}$$

Pattern 11 lists column transposition patterns for every row in a table form.

In a third stage, to transpose addresses in the column direction, transposition of each row is performed as shown in pattern 12 based on transposition pattern $\{P(j)\}=P_A$ of a predetermined row.

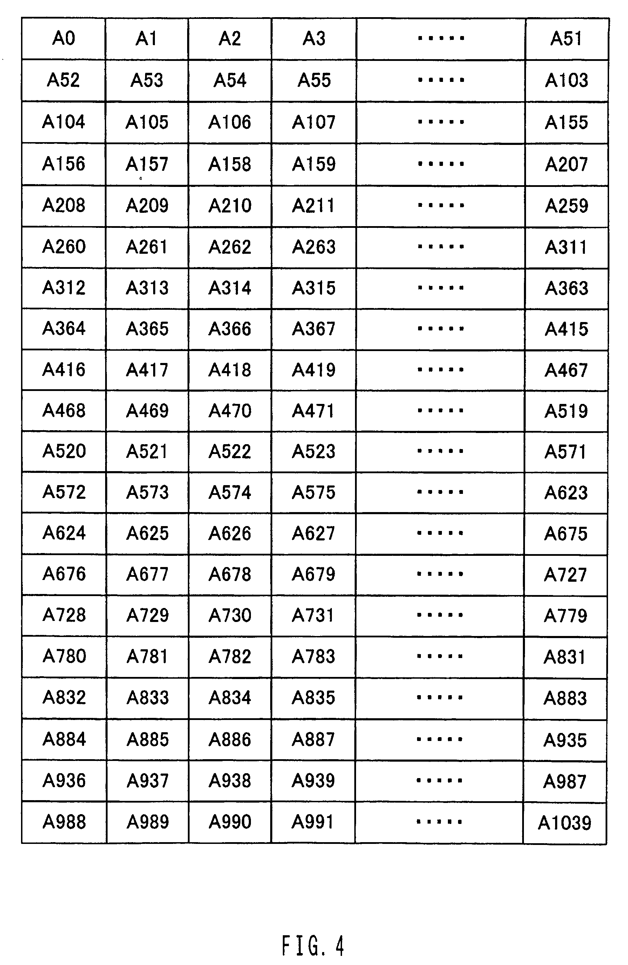

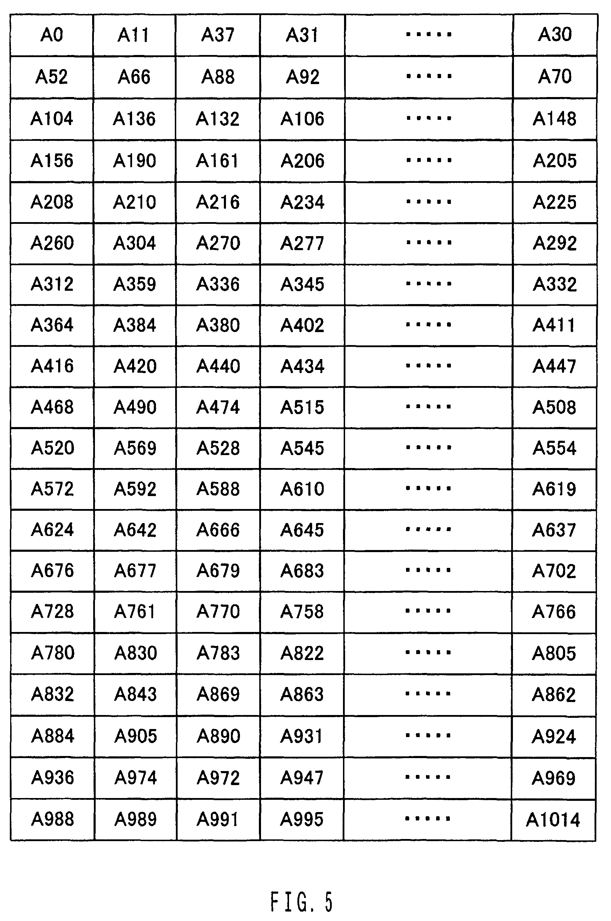

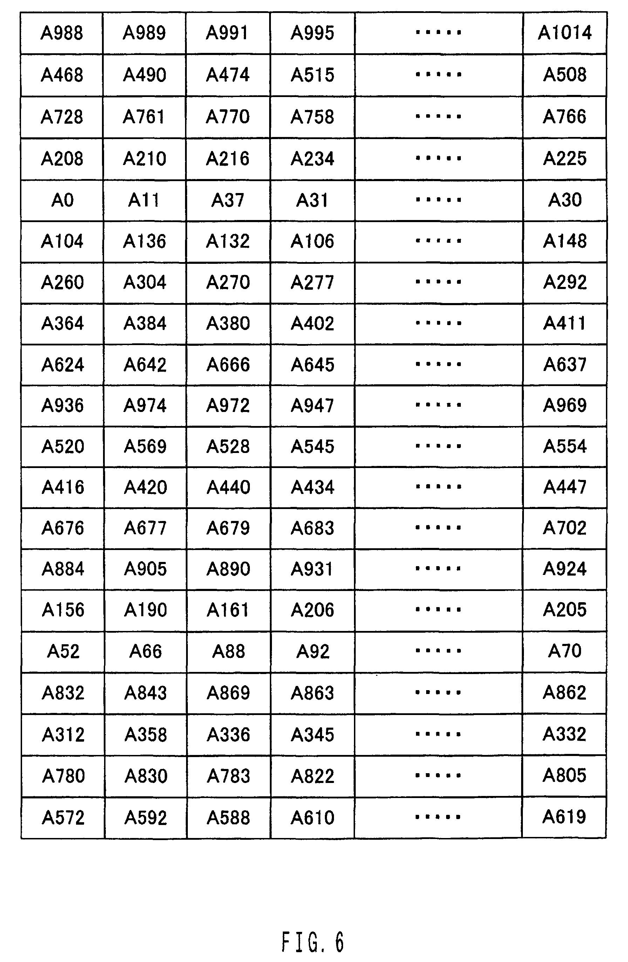

Then, the transposition of data according to the column transposition patterns generated using the above-described method will be explained with reference to FIG.4 to FIG.6. FIG.4 is a drawing showing an address array before carrying out interleaving and FIG.5 is a drawing showing an address array with columns transposed according to column transposition patterns and FIG.6 a drawing showing an address array with rows transposed according to row transposition patterns after transposing columns. A0 to A1039 shown in FIG.4 to FIG.6 denote addresses of the matrix.

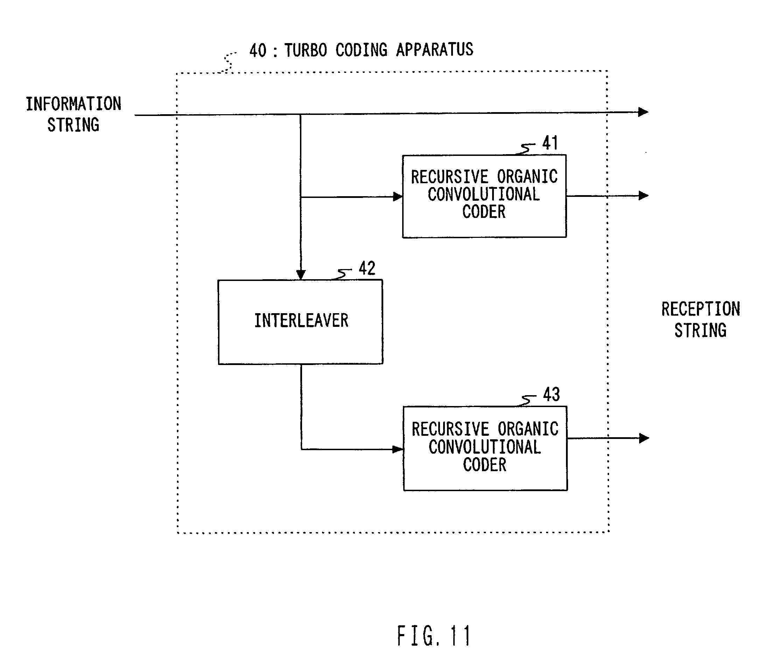

First, 1040-bit data $\{0,1,2,\cdots,1039\}$ is written in the row direction in memory in which addresses are allocated as shown in FIG.4. Then, addresses of the respective rows shown in FIG.11 are rearranged as shown in FIG.5 according to column transposition patterns $\{c_0(i)\}$, $\{c_1(i)\}$,$\cdots\{c_{19}(i)\}$.

In a third stage, data after column transposition shown in FIG.5 is rearranged according to row transposition pattern $\{P(j)\}=P_A$ as shown in FIG.6.

Finally, if the data rearranged as shown in FIG.6 is read in the column direction, the data is read in order of A998,A468,A728, ···,A989,A490,A761,··· ···,A991,A474,A770,······,A995,A515,A758,······ A1014,A508,A766. In this case, since data corresponding to each address is read, the data read becomes $\{998,468,728, \cdots\cdots,989,490,761,\cdots\cdots,991,474,770,\cdots\cdots,995,515,758,\cdots\cdots \cdots,1014,508,766\}$. This is how data is rearranged using interleave patterns.

However, the above-described conventional interleave address generation method needs to carry out modulo calculations when determining transposition pattern $\{c(i)\}$ of the basic column and a column transposition pattern for every row, and therefore involves a problem that a large amount of calculations is required to generate interleave addresses and the load of generating interleave patterns increases. For example, when interleave size K=1000, calculating a transposition pattern of a basic column and a column transposition pattern for every row requires $20 \times 52$ = 1040 modulo calculations. Therefore, the processing load increases especially when the interleave size increases.

Furthermore, there is a problem with the above-described circuit for generating interleave addresses that since modulo calculations are performed to determine basic column transposition pattern $\{c(i)\}$ and a row transposition pattern for every column, calculations of several cycles are required until an interleave pattern is generated, which causes a processing delay.

Disclosure of Invention

The present invention has been implemented in view of the above problems and it is an object of the present invention to provide, when prime interleave addresses are generated, an interleave address generation apparatus capable of reducing processing load of generating interleave patterns.

This object is attained by calculating a transposition pattern of a basic column and storing in memory beforehand when prime interleaving is performed and generating interleave addresses based on the transposition pattern of the basic column calculated beforehand.

Brief Description of Drawings

FIG. 1 illustrates a method of generating interleave addresses and interleave patterns according to conventional prime interleaving;

FIG.2 illustrates transposition of 21-bit data using conventional interleave patterns;

FIG. 3 illustrates a case with interleave size K=1000 of the interleave address generation method according to conventional prime interleaving;

FIG.4 illustrates an address array before carrying out conventional interleaving;

FIG.5 illustrates an address array with columns transposed according to the conventional column transposition patterns;

FIG.6 illustrates an address array with rows transposed according to row transposition patterns after conventional column transposition is performed;

FIG.7 is a block diagram showing a configuration of an interleave address generation apparatus according to Embodiment 1 of the present invention;

FIG.8 is a flow chart illustrating a Ptr$_i$(j) calculation method according to Embodiment 1 of the present invention;

FIG.9 illustrates an address array before carrying out interleaving according to Embodiment 1 of the present invention;

FIG.10 illustrates interleave patterns when K=1000 according to Embodiment 1 of the present invention;

FIG.11 is a block diagram showing a configuration of a turbo coding apparatus according to Embodiment 2 of the present invention;

FIG.12 is a block diagram showing a configuration of a turbo decoding apparatus according to Embodiment 3 of the present invention; and

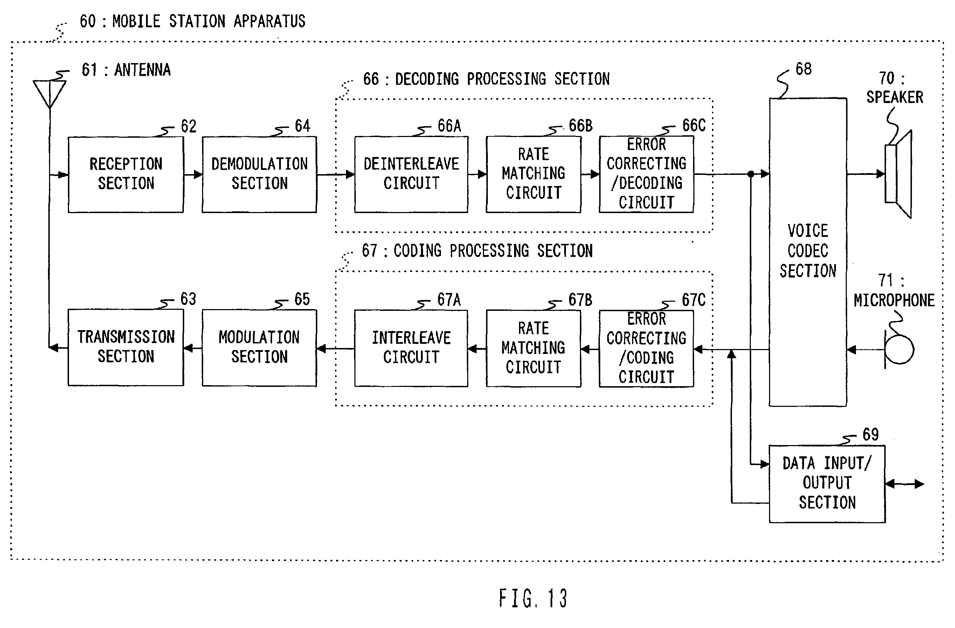

FIG.13 is a block diagram showing a configuration of a mobile station apparatus according to Embodiment 4 of the present invention.

Best Mode for Carrying out the Invention

Before explaining an interleave address generation apparatus according to each embodiment, an interleave address generation method according to the present invention will be explained first. Interleave address generation consists of two stages and these will be explained one by one below. By the way, the tables used in the following explanations are the same as those used to explain the conventional technology.

(First stage)

In a first stage, the number of rows R and the number of columns C of a matrix to perform prime interleaving are determined. The number of rows R is determined according to the value of interleaving size K (K = 320 to 8192) corresponding to a data transfer speed notified from the other end of communication beforehand under the following conditions:

R = 10 (K = 481 to 530)
R = 20 (K outside the above range)

Interleave size K denotes the size of data processed in one frame (10 msec units).

Furthermore, the number of columns C is determined under the following conditions:

(1) When R = 10, C = 53
(2) When R = 20,

① Minimum p which satisfies expression (1) and is a prime number at the same time is found.

$$0 \leqq (p+1)\text{-}K/R \tag{1}$$

② The calculation shown in expression (2) is performed using p found in ①.

$$\text{if } (0 \leqq p\text{-}K/R) \text{ then go to } ③ \text{ else } C = p+1 \tag{2}$$

③ C is determined by expression (3).

$$\text{if } (0 \leqq p\text{-}1\text{-}K/R) \text{ then } C = p\text{-}1 \text{ else } C = p \tag{3}$$

In this way, the number of rows R and number of columns C are determined to perform prime interleaving.

In a second stage, the address of the data written to the matrix is newly calculated when prime interleaving is carried out. By the way, in this Specification, each address newly calculated is called an "interleave address" and an array of interleave addresses on a matrix is called an "interleave pattern". That is, an "interleave address" corresponds to a component of an "interleave pattern" which is expressed by a matrix.

Here, terms that will be used in the following explanation are defined as follows:

"Column transposition pattern value" $c(i)$ $(i=1,2, \cdots)$ is an element of "column transposition pattern" $c_0=\{c(i)\}$ expressed by a set.
"Shift coefficient" $q(j)$ $(j=1,2,\cdots)$ is an element of "shift coefficient set" $\{q(j)\}$ expressed by a set.
"Row transposition pattern value" $P(j)$ $(j=1,2,\cdots)$ is an element of "row transposition pattern" $\{P(j)\}$ expressed by a set.

When a set is expressed, curly brackets {} are used to distinguish a set from an element thereof.

An interleave address generated slightly varies depending on which value of C=p, C=p+1 and C=p-1 is the number of columns C calculated in the first stage, and therefore the method of calculating interleave addresses will be explained separately for when C=p, C=p+1 or C=p-1.

<A: when C=p>

(A-1)

First, a known primitive prime number $g_0$ that has a one-to-one correspondence with a minimum prime number p shown in Table 1 that satisfies expression (1) is selected.

(A-2)

Then, the row transposition pattern is stored in memory (first storing means). The following three patterns are defined as row transposition patterns according to the number of rows R:

$P_A$:{19,9,14,4,0,2,5,7,12,18,10,8,13,17,3,1,16,6 ,15,11} for R=20
$P_B$:{19,9,14,4,0,2,5,7,12,18,16,13,17,15,3,1,6,1 1,8,10} for R=20
$P_C$:{9,8,7,6,5,4,3,2,1,0} for R=10

This row transposition pattern is assigned for interleave size K as shown in Table 2.

(A-3)

Next, transposition pattern of the basic column $c_0=\{c(i)\}$ $(i=1,2,\cdots,p-2$, and $c(0)=1$ $c(p-1)=0)$ is calculated from expression (12) and stored in memory (second storing means).

$$c(i)=[g_0 \times c(i-1)]\bmod p, i=1,2,\cdots(p-2), \text{ and } c(0)=1$$

$$\text{and } c(p-1)=0 \tag{12}$$

From expression (12), the basic column transposition pattern is:

$$c_0=\{c(i)\}=\{c(0)\}=1,c(1),c(2),\cdots,$$

$$c(p-2),c(p-1)=0\}$$

(A-4)

Then, a shift coefficient set:

$$q_0=\{q(j)\}=\{q(0)=1,q(1),q(2),\cdots,q(R-1)\}$$

is calculated and stored in memory (third storing means). Shift coefficient q(j) is calculated according to expression (5) to expression (7).

$$g.c.d\{q(j),p-1\}=1 \qquad (5)$$

$$q(j)>6 \qquad (6)$$

$$q(j)>q(j-1) \qquad j=1,2,\cdots(R-1), \text{ and } q(0) \qquad (7)$$

where, g.c.d denotes the greatest common divisor and q(j) is a prime number. Furthermore, suppose a shift coefficient about the first row is q(0)=1. For example, when R=5, q(j)={1,7,11,13,17}.

(A-5)

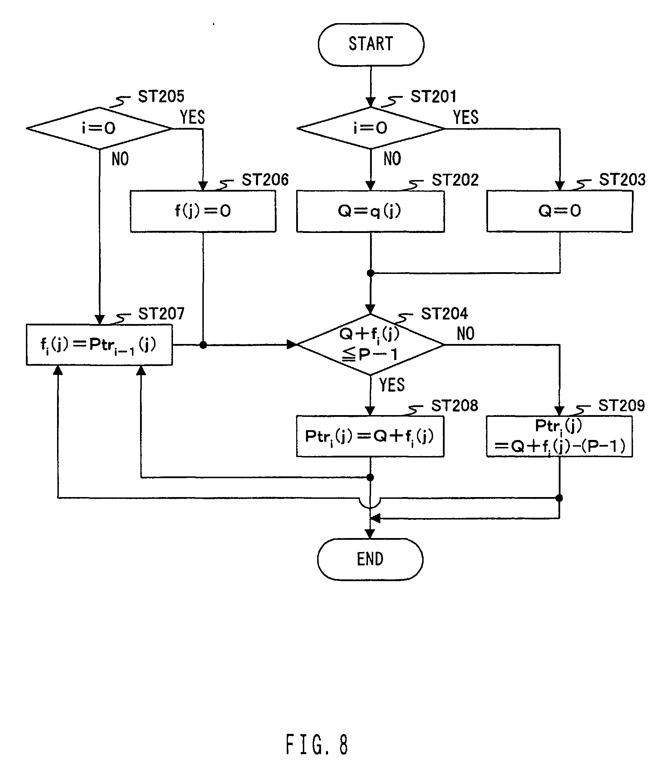

Then, memory address $Ptr_i(j)$ indicating the address of the transposition pattern of the basic column $c_0=\{c(i)\}$ stored in the memory ( second storing means ) is calculated based on the row number. Then, {c(i)} according to memory address $Ptr_i(j)$ is output from the memory. That is, when $Ptr_i(j)$ is input to the memory, $c(Ptr_i(j))$ is read from the memory.
The method of calculating $Ptr_i(j)$ will be explained with reference to the flow chart shown in FIG.8. FIG.8 is a flow chart illustrating a $Ptr_i(j)$ calculation method.
In ST201, it is determined whether the number of columns i is 0 or not, first. In the case where i=0, Q is set to 0 in ST203 and the process moves on to ST204. In the case where i≠0, Q is set to q(j) in ST202 and the process moves on to ST204.
In ST204, the sum of Q determined in ST202 or ST203 and $f_i(j)$ determined in ST206 or ST207, which will be described later, is compared with (p-1), and if p-1≧ Q+$f_i(j)$, the process moves on to ST208 and if p-1<Q+$f_i(j)$, the process moves on to ST209. In ST208, $Ptr_i(j)$ is determined as Q+$f_i(j)$ and in ST209, $Ptr_i(j)$ is determined as Q+$f_i(j)$-(p-1).
On the other hand, in ST205, it is determined whether the number of columns i is 1 or not. In the case where i=0, $f_i(j)$=0 in ST206 and in the case where i≠0, $f_i(j)$= $Ptr_{i-1}(j)$ in ST207. In this way, $Ptr_i(j)$ is determined as any one of 0 to C-1.

(A-6)

Then, an address offset value is calculated. The address offset value is calculated by multiplying row transposition pattern value P(j) read from memory based on the row number by the number of columns C calculated in stage 1. That is, the address offset value becomes P(j)×C.
In this way, $c(Ptr_i(j))$ and address offset value P(j)×C are calculated based on the row number.
Then, the column transposition pattern value $c(Ptr_i(j))$ calculated based on the same row number is added to address offset value P(j)×C with synchronization established between the two. This addition result $c(Ptr_i(j))$+P(j)×C indicates the interleave address at row (i+1), column (j+1). An interleave pattern is generated by carrying out this operation within the range of i=0 to C-1, j=0 to R-1 and setting the p(=C)th column to c(p-1)=0.

<B: when C=p+1>

(B-1)

Processed in the same way as in the case of (A-1).

(B-2)

Processed in the same way as in the case of (A-2).

(B-3)

The basic column transposition pattern $c_0=\{c(i)\}$ (i=1,2,···, p-2, and c(0)=1,c(p-1)=0, c(p)=p) is calculated from expression (13) and stored in memory (second storing means).

$$c(i)=[g_0 \times c(i-1)]modp, i=1,2,\cdots,(p-2),c(0)=1, \text{ and}$$

$$c(p-1)=0, \text{ and } c(p)=p \qquad (13)$$

From expression (13), the transposition pattern of the basic column is:

$$c_0=\{c(i)\}=\{c(0)=1,c(1),c(2),\cdots,c(p-2),$$

$$c(p-1)=0,c(p)=p\}$$

(B-4)

Processed in the same way as in the case of (A-4).

(B-5)

Processed in the same way as in the case of (A-5).

(B-6)

An address offset value is calculated in the case of (A-6). Then, $c(Ptr_i(j))$ calculated based on the same row number is added to the address offset value $P(j) \times C$ with synchronization established between the two. This addition result indicates the interleave address at row (i+1), column (j+1). An interleave pattern is generated by carrying out this operation within the range of i=0 to C-1, j=0 to R-1 and setting the p(=C-1)th column to $c_j(p-1)=0$ and the p+1(=C) th column to $c_j(p-1)=p$.

<C: when C=p-1>

(C-1)

Processed in the same way as in the case of (A-1).

(C-2)

Processed in the same way as in the case of (A-2).

(C-3)

The basic column transposition pattern $c_0=\{c(i)\}$ (i=1,2,$\cdots\cdots$, p-2) is calculated from expression (14) and stored in memory (second storing means).

$$f(i)=[g_0 \times f(i-1)]modp, i=1,2,\cdots,(p-2), c(0)=1$$

$$c(i)=f(i)-1 \qquad (14)$$

From expression (14), the transposition pattern of the basic column is:

$$c_0=\{c(i)\}=\{c(0)=1,c(1),c(2),\cdots,c(p-2)\}$$

(C-4)

Processed in the same way as in the case of (A-4).

(C-5)

Processed in the same way as in the case of (A-5).

(C-6)

An address offset value is calculated as in the case of (A-6). Then, $c(Ptr_i(j))$ calculated based on the same row number is added to address offset value $P(j) \times C$ with synchronization established between the two. This addition result indicates the interleave address at row (i+1), column (j+1). An interleave pattern is generated by repeating this operation from i=0 to C-1, j=0 to R-1.

Here, the above-described method of generating interleave addresses will be explained more specifically taking a case of K=1000 as an example.

In a first stage, the number of rows R is determined first. Since K=1000, the number of rows R is determined as R=20. Then, the number of columns C is determined. When R=20 and K=1000 are substituted into expression (1),

$$0 \leqq (p+1)\text{-}1000/20$$

is obtained. Since minimum p that satisfies this and is a prime number at the same time is 53, p=53 is determined. Then, when R=20, K=1000 and p=53 are substituted into expression (2),

$$p\text{-}K/R = 53\text{-}10000/20 = 3 \geqq 0$$

is obtained. Thus, the process moves on to expression (3). When R=20, K=1000 and p=53 are also substituted into expression (3),

$$p\text{-}1\text{-}K/R = 53\text{-}1\text{-}1000/20 = 2 \geqq 0$$

is obtained. Thus, C=p-1=52, and the number of columns is determined as 52 columns.

In this way, the number of columns R=20 and number of columns C=p-1=52 of the matrix are determined to perform prime interleaving.

In a second stage, an interleave address is calculated based on memory address $Ptr_i(j)$ and address offset value.

First, before carrying out interleave processing, transposition pattern of the basic column {c(1)}, row transposition pattern {P(j)} and shift coefficient set {q(j)} are calculated and stored in memory.

First, from Table 1, the row transposition pattern when K=1000 is:

$$\{P(j)\} = P_A = \{19,9,14,4,0,2,5,7,12,18,10,8,13,17,3$$

$$,1,16,6,15,11\}$$

This value is stored in memory (first storing means ) .

Then, a transposition pattern of the basic column {c(i)} is calculated according to expression (4),

$$c_0 = \{c(i)\} = \{c(0),c(1),c(2),\cdots,c(51)\}$$

$$= \{0,1,3,7,15,31,10,21,43,34,16,33,14,29,6,13,27$$

$$,2,5,11,23,47,42,32,12,25,51,50,48,44,36,20,41,30,8,$$

$$17,35,18,37,22,45,38,24,49,46,40,28,4,9,19,39,26\}$$

This value is stored in memory (second storing means).

Furthermore, from expression (5) to expression (7),

$$q(j)=\{1,7,11,13,17,19,23,29,31,37,41,43,47,53,5$$

$$9,61,67,71,73,79\}$$

This value is stored in memory (third storing means ) .

Furthermore, $\{0,0,0,\cdots\cdots 0,0\}$ is stored in the FIFO as the initial value.

Then, memory address $Ptr_i(j)$ is calculated within the range of i=0 to C-1, j=0 to R-1 according to the flow chart shown in FIG.8. Memory address $Ptr_i(j)$ denotes the address of the second storing means in which basic column transposition pattern $\{c(i)\}$ is stored.

First, a case with i=0, j=0 will be explained with reference to FIG.8. Since i=0, Q is set to 0 in ST203, and the process moves on to sT204. Moreover, since i=0 in ST205, $f_0(0)$ is set to 0 in ST206. In ST204, Q=0 set in ST203 is added to $f_0(0)=0$ set in ST207 and the addition result $Q+f_0(0)=0$ is compared with (p-1)=52. Since $p-1 \geq Q+f_0(0)$, the process moves on to ST208. In ST208, $Ptr_0(0)$ is set to $Q+f_0(0)=0$.

In this case, $c(Ptr_0(0))=c(0)=1$ is read from memory according to $Ptr_0(0)$.

Furthermore, when i=0, j=0, the address offset value is calculated as $P(0)\times C=19\times 52=988$.

Then, $c(PTr_0(0))=1$ is added to address offset value $P(0)\times C=988$ with synchronization established between the two and the addition result $c(Ptr_0(0))+P(0)\times C=1+988=989$ denotes the interleave address at row 1, column 1.

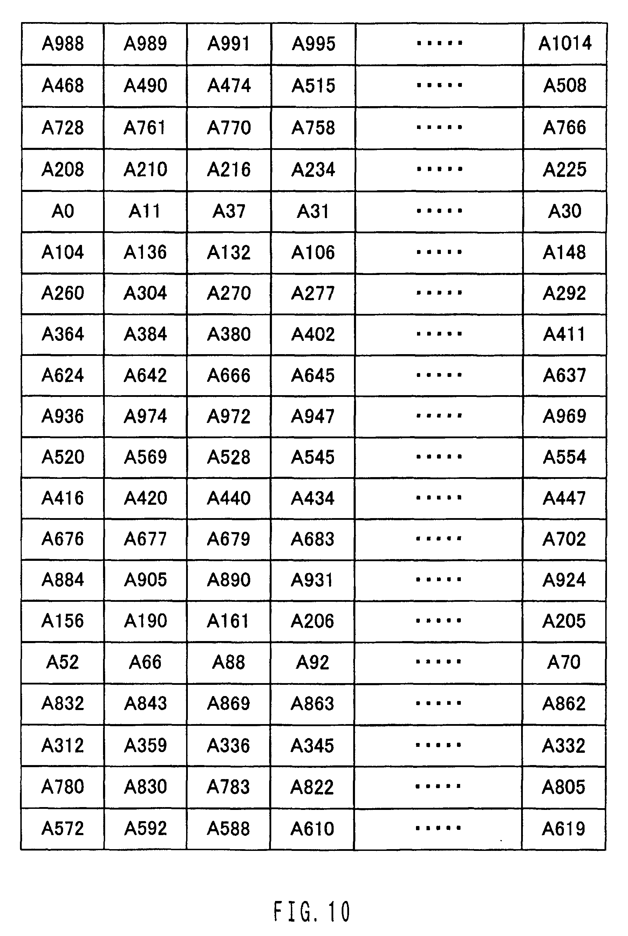

The interleave pattern shown in FIG. 10 is generated by repeating this operation from i=0 to C-1, j=0 to R-1.

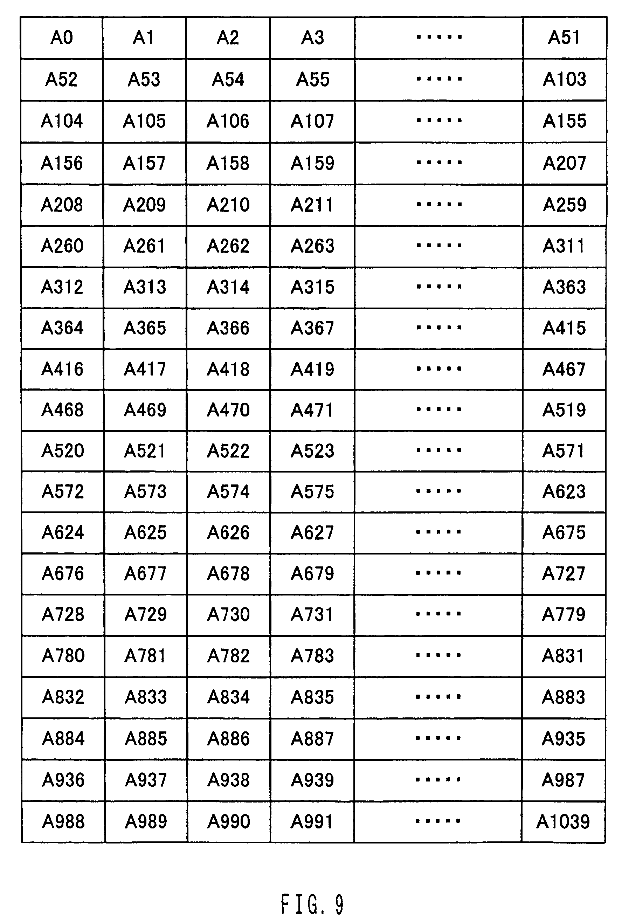

Finally, data is rearranged using the interleave pattern generated above. Rearrangement of data using the above interleave patterns will be explained with reference to FIG.9 and FIG.10. FIG.9 illustrates an address array before carrying out interleaving and FIG.10 illustrates an address array (interleave pattern) when K=1000 after carrying out interleaving.

First, 1040-bit data $\{0,1,2,\cdots\cdots,52,53,54\cdots\cdots,104,105,106,\cdots\cdots,1039\}$ is written sequentially in memory in which addresses are allocated as shown in FIG.9. That is, data N (N=0 to 1039) is written at address N (N=0 to 1039). More specifically, data 0 is written at address A0, data 1 is written at address A1, data 2 is written at address A2, and the subsequent data is also written according to the same rule.

Then, addresses of each row shown in FIG.9 are updated according to the above interleave address generation method as shown in FIG.10.

Then, when data is read starting from the 1st row, 1st column in the column direction according to the addresses rearranged as shown in FIG.10, data is read as A989,A468,A728, $\cdots\cdots$,A989,A490,A761,$\cdots\cdots$ A991,A474,A770,$\cdots\cdots$,A1014,A508,A766,$\cdots\cdots$,A619. In this case, since the data corresponding to each address is read, the data read is as $\{988,468,728, \cdots\cdots,989,490,761, \cdots\cdots 991,474,770,\cdots\cdots,1014,508,766,\cdots\cdots,619\}$. This is how data is rearranged using interleave patterns.

As shown above, the address generation method using the interleave address generation apparatus according to this embodiment calculates a transposition pattern of the basic column and stores in memory beforehand, eliminates the need to execute a modulo calculation when interleave addresses are generated, and can thereby reduce the processing load of generating interleave patterns.

Furthermore, this embodiment calculates an address offset value, calculates a column transposition pattern for every row, reducing a modulo calculation count, and can thereby generate interleave patterns at high speed and reduce the load of generating interleave patterns.

Furthermore, this embodiment generates memory address $Ptr_i(j)$ calculated for every row number of each column, reads a transposition pattern of the basic column according to this memory address $Ptr_i(j)$ generated to calculate the row transposition pattern of each row, and can thereby calculate a column transposition pattern of each row in one clock. Therefore, the present invention can generate interleave patterns at high speed.

With reference now to the attached drawings, embodiments of the present invention will be explained in detail below.

(Embodiment 1)

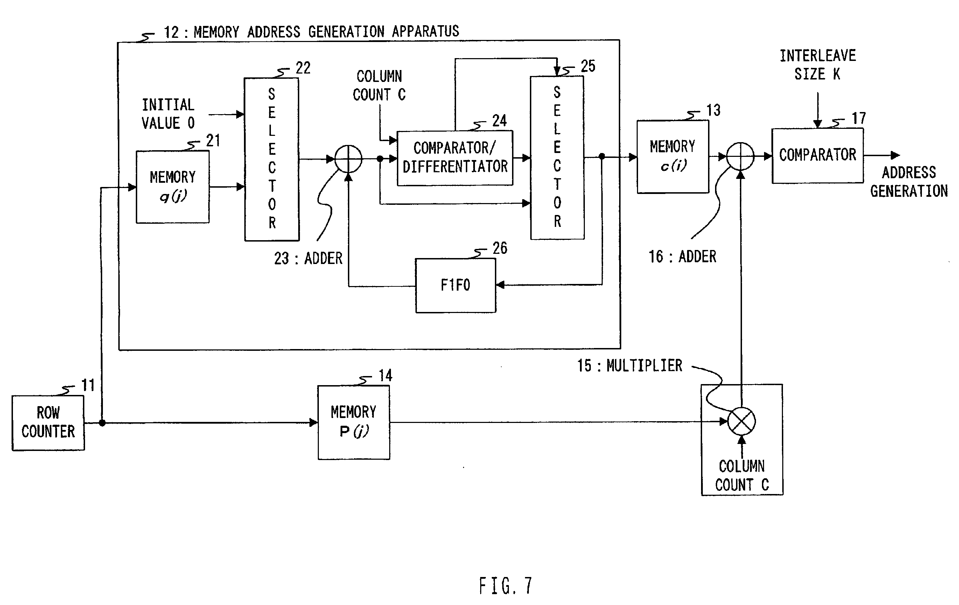

FIG.7 is a block diagram showing a configuration of an interleave address generation apparatus according to Embodiment 1 of the present invention. As shown in this figure, the interleave address generation apparatus according to this embodiment is constructed of row counter 11, memory address generation apparatus 12, memory 13 (second storing means), memory 14 (first storing means ) , multiplier 15 (address offset value calculating means), adder 16 and comparator 17. Memory address generation apparatus 12 is constructed of memory 21 (third storing means),selector22,adder23,comparator/differentiator 24, selector 25 and FIFO 26.

Row counter 11 outputs row numbers on each row one by one starting from the first row to memory 14 and memory 21. In this case, when the row number of the Mth row is output, j=M-1 is output. That is, row numbers on the 1st column are output from j=0 to j=R-1 and then row numbers on the 2nd row are output from j=0 to j=R-1 one by one. In this case, since the interleave address at row j+1 and column N is generated from output j with the row number on the Nth row from row counter 11, row numbers necessary to generate interleave patterns are output from row counter 11 by repeating this processing up to column C.

Memory 14 stores beforehand row transposition pattern {P(j)} corresponding to interleave size K notified beforehand and outputs row transposition pattern value P(j) corresponding to row number j output by row counter 11 to multiplier 15. Multiplier 15 calculates address offset value P(j)×C by multiplying row transposition pattern value P(j) from memory 14 by the number of columns C and outputs P(j)×C to adder 16.

Memory address generation apparatus 12 calculates memory address $Ptr_i(j)$ based on the output from row counter 11 and outputs calculated $Ptr_i(j)$ to memory 13. Hereafter, the configuration of memory address generation apparatus 12 will be explained in detail.

In memory address generation apparatus 12, memory 21 stores shift coefficient set {q(j)} calculated according to interleave size K notified beforehand and expression (5) to expression (7) and outputs shift coefficient set {q(j)} corresponding to row number j from row counter 11 to selector 22. Selector 22 selects either initial value 0 or shift coefficient set {q( j )} from memory 21 and outputs to adder 23. More specifically, when shift coefficient q(j) based on a row number on the 1st column is output from memory 21, 0 is output to adder 23 and when shift coefficient q(j) based on other than the row number on the 1st column is output, shift coefficient q(j) from memory 21 is output to adder 23. Adder 23 adds up the output from FIFO 26, which will be described later, and the output from selector 23 and outputs the addition result to comparator/differentiator 24 and selector 25. Comparator/differentiator 24 compares the output from adder 23 and the value of p-1 and outputs a large/small determining signal indicating which is greater to selector 25. Comparator/differentiator 24 further outputs a value obtained by subtracting the number of rows C from the output of adder 23 to selector 25. When the large/small determining signal indicates that the output from adder 23 is larger, selector 25 outputs the output from adder 23 as $Ptr_i(j)$ to memory 13 and FIFO 26. On the contrary, when the large/small determining signal indicates that the number of columns is larger, selector 25 outputs a value obtained by subtracting the number of rows C from the output of adder 23 from comparator/differentiator 24 as $Ptr_i(j)$ to memory 13 and FIFO 26. FIFO 26 is a first-in, first-out circuit having the same number of characters as that of the number of rows R. FIFO 26 is given {0,0,0,······0} as an initial value.

Memory 13 reads $c(Ptr_i(j))$ corresponding to $Ptr_i(j)$ from comparator/differentiator 24 and outputs to adder 16. Adder 16 adds up column transposition pattern value $c(Ptr_i(j))$ output from memory 13 and the output (address offset value) of multiplier 15 and outputs the addition result to comparator 17. Of the outputs from adder 16, comparator 17 outputs only a value smaller than interleave size K as an interleave address.

This is how interleave addresses are generated.

Then, an operation of the interleave address generation apparatus in the above configuration will be explained taking a case where K=1000 as an example with reference to FIG.7 again. When K=1000, R=20 and C=p-1=52 are set under the above-described condition.

In this case, interleave addresses of the respective components of a matrix with 20 rows and 52 columns are calculated in the column direction starting from row 1, columnIsequentially. That is, interleave addresses are calculated in the column direction from row 1, column 1 to row 1, column 20 and interleave addresses on the 2nd and subsequent rows are also calculated in the column direction from row 1 to row 20 and the same processing is repeated to calculate interleave addresses on the 3rd and subsequent rows.

First, an interleave address at row 1, column 1 is generated. Row number 0 is output from row counter 11 to memory 14 and memory 21. From memory 14, P(0)=19 corresponding to row number 0 is read from memory and output to multiplier 15. Multiplier 15 multiplies output P(0)=19 of memory 14 by the number of columns C=52 and calculates an address offset value 19×52=988. Calculated address offset value 988 is output to adder 16.

Furthermore, from memory 21, q(0)=1 corresponding to row number 0 is read from memory and output to selector 22. In this case, initial value 0 is also output to selector 22. Since shift coefficient q(j) from memory 21 is a value based on a row number on the 1st column, selector 22 selects initial value 0 and outputs to adder 23. Adder 23 adds up the output 0 of selector 22 and output 0 of FIFO 26, which results in 0, and outputs this 0 to comparator/differentiator 24 and selector 25. Comparator/differentiator 24 subtracts the number of rows C from the output of adder 23 and outputs the subtraction result to selector 25 and since the number of columns C=52 is smaller than the output 0 of adder 23, a large/small determining signal indicating that the number of columns is larger is output to selector 25. Based on the large/small determining signal from comparator/differentiator 24, selector 25 selects output 0 from adder 23 and $Ptr_0(0)=0$ is output to memory 13 and FIFO 26. FIFO 26 writes the output 0 of comparator/differentiator 25 in memory.

Memory 13 reads $c(Ptr_0(0))=c(0)=1$ from memory based on output $Ptr_0(0)=0$ of comparator/differentiator 24 and outputs to adder 16. Adder 16 adds up output c(0)=1 of memory 13 and the output 988 of multiplier 15 and outputs the addition result 1+988=989 to comparator 17. Since the output 989 of adder 16 is smaller than interleave size K=1000, comparator 17 outputs 989 as the interleave address at row 1, column 1 of the new matrix.

Then, an interleave address at row 2, column 1 is generated. Row number 1 is output from row counter 11 to memory 14 and memory 21. The signal output to memory 21 is subjected to the same processing as the case where row number 0 is output and $Ptr_0(1)=0$ is output to memory 13 and FIFO 26. From memory 14, P(1)=9 corresponding to row number 1 is read and output to multiplier 15. Multiplier 15 multiplies output P(1)=9 of memory 14 by the number of columns C=52 to obtain an address offset value $19 \times 52 = 468$. The calculated address offset value 468 is output to adder 16. Adder 16 adds up output c(0)=1 of memory 13 and the output 468 of multiplier 15 and outputs the addition result 1+468=469 to comparator 17. Since the output 469 of adder 16 is smaller than interleave size K=1000, comparator 17 outputs 469 as the interleave address at row 2, column 1 of the new matrix.

The same processing is carried out also when row number 2 and subsequent numbers are output from row counter 11 and the interleave addresses on the 1st column of the new matrix are determined.

Row counter 11 is reset when row number 19 is output. After the reset, counter 11 outputs row numbers starting from 0 to generate interleave addresses on the 2nd column again and interleave addresses on the 2nd column are generated through the same processing as for the 1st column. Row counter 11 carries out the same processing also for the 3rd and subsequent columns and by repeating this processing up to the 52nd column, obtains the interleave patterns shown in FIG.10.

Thus, the interleave address generation apparatus according to this embodiment stores the calculation results of modulo calculations in memory 13 beforehand, which eliminates the need to carry out modulo calculations to generate interleave addresses, and can thereby reduce the processing load of generating interleave patterns.

Furthermore, the interleave address generation apparatus according to this embodiment calculates column transposition patterns for every row by calculating address offset values and thereby reduces a modulo calculation count, making it possible to generate interleave patterns at high speed and also reduce the processing load of generating interleave patterns.

Furthermore, a transposition pattern of the basic column is read from memory 13 according to this memory address $Ptr_i(j)$, an address offset value is added to this read transposition pattern of the basic column to generate a column transposition pattern on each row, and therefore it is possible to determine the column transposition pattern on each row in one clock. Thus, according to this embodiment, it is possible to generate interleave patterns at high speed.

(Embodiment 2)

Embodiment 2 will describe a turbo coding apparatus equipped with the interleave address generation apparatus according to Embodiment 1. FIG.11 is a block diagram showing a configuration of the turbo coding apparatus according to Embodiment 2.

Turbo coding apparatus 40 according to this embodiment is constructed of recursive organic convolutional coders 41 and 43 and interleaver 42.

Recursive organic convolutional coder 41 carries out coding on an information string input with recursive organic convolutional codes. Interleaver 42 carries out the interleaving explained in Embodiment 1 on the information string input in the same way. Recursive organic convolutional coder 43 is fed the information string output from interleaver 42 and carries out coding with recursive convolutional codes.

Then, an operation of turbo coding apparatus 40 in the above configuration will be explained. The information string input to turbo coding apparatus 40 is input to recursive organic convolutional coder 41 and interleaver 42. The information string input to turbo coding apparatus 40 is output as is without being subjected to coding processing. The information string input to recursive organic convolutional coder 41 is subjected to coding with recursive organic convolutional codes. On the other hand, the information string input to interleaver 42 is subjected to interleave processing using interleave patterns shown in Embodiment 1 and output to recursive organic convolutional coder 43. The information string input to recursive organic convolutional coder 43 is subjected to coding with recursive organic convolutional codes and output. Thus, a 3-bit information string made up of the information string output without being subjected to coding processing combined with the information string output after being subjected to coding processing by recursive organic convolutional coders 41 and 43 is output as a transmission string from turbo coding apparatus 40.

Thus, turbo coding apparatus 40 according to this embodiment reduces a modulo calculation count by applying the interleave address generation apparatus shown in Embodiment 1 to interleaver 42, and can thereby reduce the amount of calculations when interleaving is carried out.

This makes it possible to implement turbo coding apparatus 40 with high-speed interleave processing capability.

This embodiment has described the case where the interleave address generation apparatus according to Embodiment 1 is applied to the turbo coding apparatus, but the present invention is not limited to this and is also applicable to a coding apparatus carrying out interleaving other than the turbo coding apparatus.

(Embodiment 3)

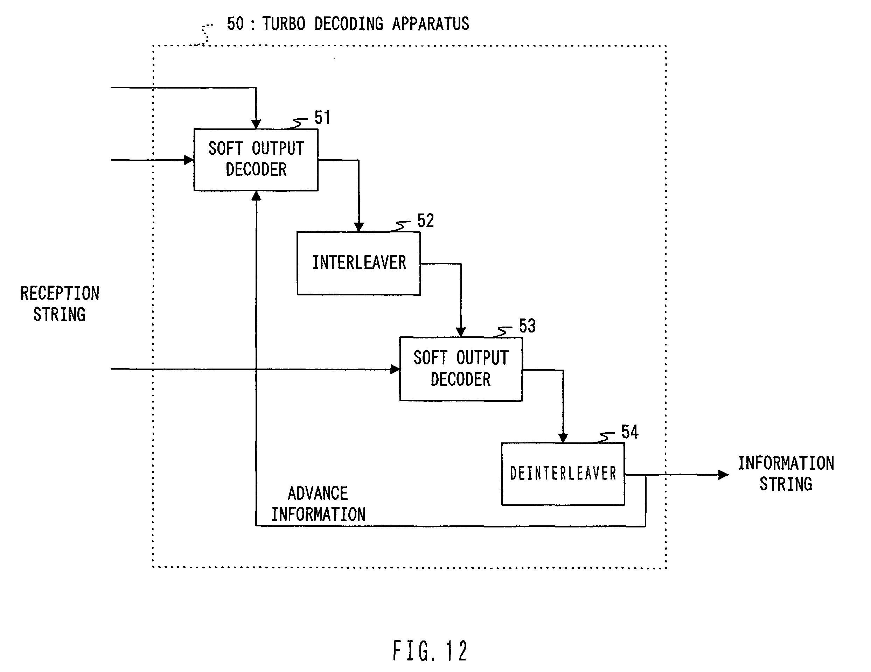

Embodiment 3 will describe a turbo decoding apparatus equipped with the interleave address generation apparatus according to Embodiment 1. This turbo decoding apparatus receives and decodes a code string output from the turbo coding apparatus according to Embodiment 2. FIG.12 is a block diagram showing a configuration of the turbo decoding apparatus according to Embodiment 3.

Turbo decoding apparatus 50 according to this embodiment is constructed of soft output decoders 51 and 53, interleaver 52 and deinterleaver 54.

Soft output decoder 51 carries out error correcting/decoding on the reception string subjected to coding processing by recursive organic convolutional coder 41 described in Embodiment 2 and the reception string output without being subjected to coding processing based on advance information from deinterleaver 54 which will be described later. This advance information is soft decision information of a reception string one bit ahead. Interleaver 52 carries out interleave processing on the output of soft output decoder 51 using the interleave patterns shown in Embodiment 1.

Soft output decoder 53 carries out error correcting/decoding on the reception string subjected to coding processing by recursive organic convolutional coder 43 described in Embodiment 2 and the output of interleaver 52 based on the soft decision information. Deinterleaver 54 carries out deinterleave processing on the code string output from soft output decoder 53 using the interleave patterns shown in Embodiment 1 to obtain an information string and at the same time outputs the processing result to soft output decoder 51 as the advance information.

Then, an operation of turbo decoding apparatus 50 in the above configuration will be explained using FIG. 12.

The code string coded by recursive organic convolutional coder 41 and the code string corresponding to the original information string are decoded by soft output decoder 51 based on the advance information from deinterleaver 54. The information string decoded by soft output decoder 51 is subjected to interleave processing by interleaver 52 according to the interleave patterns shown in Embodiment 1 and output to soft output decoder 53. The output from interleaver 52 and the code string coded by recursive organic convolutional coder 41 are decoded by soft output decoder 53 based on the soft decision information and output to deinterleaver 54. Deinterleaver 54 carries out deinterleave processing on the output of soft output decoder 53 according to the interleave patterns shown in Embodiment 1 to obtain an information string. Furthermore, the deinterleaved information string is output to soft output decoder 51 as advance information. Thus, decoding is performed repeatedly by getting feedback of advance information.

Thus, turbo decoding apparatus 50 according to this embodiment eliminates the need to carry out modulo calculations to perform decoding processing by applying the interleave address generation apparatus described in Embodiment 1 to interleaver 52, and can thereby reduce the amount of calculations for carrying out interleaving.

This provides an expectation for implementation of turbo decoding apparatus 50 with high-speed interleave processing.

This embodiment has described the case where the interleave address generation apparatus according to Embodiment 1 is applied to the turbo decoding apparatus, but the present invention is not limited to this and is also applicable to any decoding apparatus that carries out interleaving.

(Embodiment 4)

Embodiment 4 will describe a mobile station apparatus using the turbo coding apparatus shown in Embodiment 2 and turbo decoding apparatus shown in Embodiment 3. FIG.7 is a block diagram showing a configuration of a mobile station apparatus according to Embodiment 4.

As shown in this figure, mobile station apparatus 60 is constructed of antenna 61, reception section 62, transmission section 63, demodulation section 64, modulation section 65, decoding processing section 66, coding processing section 67, voice CODEC section 68, data input/output section 69, speaker 70 and microphone 71. Decoding processing section 66 is constructed of deinterleave circuit 66A, rate matching circuit 66B and error correcting/decoding circuit 66C, and coding processing section 67 is constructed of interleave circuit 67A, rate matching circuit 67B and error correcting/coding circuit 67C.

Reception section 62 carries out radio reception processing such as down-conversion on a reception signal received via antenna apparatus 61. Demodulation section 64 carries out predetermined modulation processing such as CDMA on the output of reception section 62. Deinterleave circuit 66A of decoding processing section 66 rearranges the output data of demodulation section 64 using the interleave patterns shown in Embodiment 1. Data rearrangement carried out by deinterleave circuit 66A is carried out in the reverse order of data rearrangement carried out by interleave circuit 67A which will be described later.

In the case where the reception signal is subjected to repetition processing, rate matching circuit 66B carries out puncturing processing on the output data of deinterleave circuit 66A and in the case where the reception signal is subjected to puncturing processing, repetition processing is applied to the output data of deinterleave circuit 66A. Error correcting/decoding circuit 66C carries out error correcting/decoding processing such as Viterbi decoding, etc. shown in Embodiment 3 on the output of rate matching circuit 66B and outputs to voice CODEC section 68 and data input/output apparatus 69. Of the output of error correcting/decoding circuit 66C, voice CODEC section 68 decodes the voice signal and generates decoded voice from speaker 70. Of the output of error correcting/decoding circuit 66C, data input/output section 69 decodes signals other than the voice signal to obtain reception data.

On the other hand, voice CODEC section 68 codes the voice signal captured via microphone 71 and outputs to error correcting/coding circuit 67C. Data input/output apparatus 69 captures a transmission signal other than the voice signal and outputs to error correcting/coding circuit 67C. Error correcting/coding circuit 67C carries out error correcting/coding processing such as convolutional coding processing shown in Embodiment 3 on the outputs of voice CODEC section 68 and data input/output section 69 and outputs to rate matching circuit 67B. Rate matching circuit 67B carries out repetition processing or puncturing processing on the output of error correcting/coding circuit 67C and outputs to interleave circuit 67A. Interleave circuit 67A rearranges the output data of demodulation section 64 for the output of rate matching circuit 67B using the interleave patterns shown in Embodiment 1 and outputs to modulation section 65. Modulation section 65 carries out predetermined modulation processing such as CDMA on the output of interleave circuit 67A and outputs to transmission section 63. Transmission section 63 carries out predetermined radio transmission processing such as up-conversion on the output signal of modulation section 65 and transmits the output signal via antenna 61.

An operation during transmission of mobile station apparatus 60 in the above configuration will be explained using FIG.7. During voice transmission, a voice signal captured from microphone 71 is AD-converted, coded by voice CODEC apparatus 68 and the coded data is input to error correcting/coding circuit 67C and subjected to convolutional coding. The data subjected to convolutional coding at error correcting/coding circuit 67C is output to rate matching circuit 67B, subjected to repetition processing or puncturing processing and output to interleave circuit 67A. Interleave circuit 67A performs data transposition using the interleave patterns shown in Embodiment 1 and outputs to modulation section 65. The transposed data is digital-modulated by modulation section 65, DA-converted and output to transmission section 63. The digital-modulated data is converted to a radio signal at transmission section 63 and transmitted by radio via antenna 61.

On the other hand, during transmission of non-voice data, non-voice data input via data input/output section 69 is subjected to error correcting/coding processing such as convolutional coding processing by error correcting/coding circuit 67C according to the data transfer rate and output to rate matching circuit 67B. The non-voice data output to rate matching circuit 67B is subjected to processing similar to that of the above-described voice data and transmitted by radio.

Then, an operation during reception will be explained. A radio signal received via antenna 61 is subjected to predetermined radio reception processing such as down-conversion and AD conversion at reception section 62 and output to demodulation section 64. The data subjected to radio reception processing is demodulated at demodulation section 64 and output to deinterleave circuit 66A. The demodulated data is transposed in the reverse order of the interleaving during transmission at deinterleave circuit 66A and output to rate matching circuit 66B. The transposed data is subjected to repetition processing or puncturing processing at rate matching circuit 66B and output to error correcting/decoding circuit 66C. The data subjected to repetition processing or puncturing processing is subjected to error correcting/decoding processing such as Viterbi decoding at error correcting/decoding circuit 66C, output to voice CODEC section 68 in the case of voice data or output to data input/output section 69 in the case of non-voice data. The voice data is decoded at voice CODEC section 68 and the voice is output via speaker 70. The non-voice data is output to the outside via data input/output section 69.

Thus, mobile station apparatus 60 according to this embodiment uses turbo coding apparatus 40 and turbo decoding apparatus 50 including the interleave address generation apparatus according to Embodiment 1 as error correcting coding circuit 67C and error correcting decoding circuit 66C, respectively, for non-voice data and can thereby obtain a communication characteristic with high transmission quality with a low BER (bit error rate) for non-voice communications. Moreover, by adopting an interleaver configuration included in turbo coding apparatus 40 and turbo decoding apparatus 50 with a reduced number of modulo calculations, this embodiment provides the configuration of the interleave address generation apparatus of Embodiment 1 capable of obtaining coding/decoding output in one clock, and can thereby provide mobile station apparatus 60 capable of reducing the amount of calculations and reducing power consumption. On the other hand, providing spreading apparatus 65B for modulation section 65 and despreading apparatus 64A for demodulation section 64 will make this embodiment applicable to CDMA communications.

The internal configuration of mobile station apparatus 60 according to this embodiment is applicable to a base station apparatus. That is, the base station apparatus in the above-described configuration can send data by carrying out the above-described coding processing, modulation processing and radio transmission processing and receive data by carrying out the above-described decoding processing, demodulation processing and radio reception processing.

As described above, the present invention stores modulo calculation results in memory beforehand, eliminates the need for executing modulo calculations when interleave addresses are generated, and can thereby reduce the processing load of generating interleave patterns.

Furthermore, the present invention calculates address offset values, calculates column transposition patterns for every row, reduces a modulo calculation count, and can thereby generate interleave patterns at high speed and reduce the load of generating interleave patterns.

Furthermore, the present invention calculates interleave addresses based on memory addresses and address offset values calculated for every row number of each column, which eliminates the need for determining a new shift coefficient set, and can thereby reduce the amount of calculations and generate interleave patterns at high speed.

This application is based on the Japanese Patent Application No. 2000-076879 filed on March 17, 2000, entire content of which is expressly incorporated by reference herein.

Industrial Applicability

The present invention is ideally suited to an interleave address generation apparatus that makes it easier, by means of data transposition, to correct burst errors that occur in a communication path, and more particularly, to the field of interleave address generation apparatuses applicable to error correction using turbo codes.

**Claims**

1. An interleave address generation apparatus comprising:

   a row counter that outputs for every column a row number of a matrix in which interleave addresses are allocated;
   memory address generating means for generating a memory address based on the row number output from said row counter;
   address offset value calculating means for calculating an address offset value by multiplying a row transposition pattern value corresponding to the row number output from said row counter by the number of columns of said matrix; and
   adding means for adding up the column transposition pattern value corresponding to the memory address generated by said memory address generating means and said address offset value to generate an interleave address.

2. The interleave address generation apparatus according to claim 1, further comprising:

   first storing means for storing row transposition patterns of the matrix; and
   second storing means for storing column transposition patterns of said matrix, wherein
   the address offset value calculating means reads from said first storing means a row transposition pattern value corresponding to the row number output from the row counter and multiplies the read row transposition pattern value by the number of columns of said matrix to calculate an address offset value, and
   the adding means reads from said second storing means a column transposition pattern value corresponding to the memory address generated by said memory address generating means and adds up the read column transposition pattern value and said address offset value to generate an interleave address.

3. The interleave address generation apparatus according to claim 1, wherein the memory address generating means comprises:

   third storing means for storing a shift coefficient set;
   first selecting means for outputting an initial value 0 when interleave addresses on the first column are calculated, reading from the third storing means a shift coefficient corresponding to the row number output from the row counter from the third storing means when interleave addresses on the second and subsequent columns are calculated and outputting the read shift coefficient; and
   second selecting means for comparing the output of said first selecting means and the number of columns of the matrix in which interleave addresses are allocated, selecting a value obtained by subtracting the number of columns from the output value of said first selecting means as a memory address when the output of said first selecting means is greater and selecting the output value of said first selecting means when the number of columns is greater, wherein
   the output value selected by said second selecting means is output as the memory address.

**4.** The interleave address generation apparatus according to claim 3, further comprising:

memory address storing means for storing memory addresses output from said selecting means; and
second adding means for reading, when an interleave address at row j, column i of the matrix is generated, the memory address when the interleave address at row j, column i-1 is generated from said memory address storing means and adding up the read memory address and the output value of the first selecting means.

**5.** An interleaver equipped with an interleave address generation apparatus, said interleave address generation apparatus comprising:

a row counter that outputs for every column a row number of a matrix in which interleave addresses are allocated;
memory address generating means for generating a memory address based on the row number output from said row counter;
address offset value calculating means for referencing a row transposition pattern value corresponding to the row number output from said row counter, multiplying the referenced row transposition pattern value by the number of columns of said matrix and thereby calculating an address offset value; and
adding means for referencing the column transposition pattern value corresponding to the memory address generated by said memory address generating means, adding up the referenced column transposition pattern value and said address offset value and thereby generating an interleave address.

**6.** A deinterleaver equipped with an interleave address generation apparatus, said interleave address generation apparatus comprising:

a row counter that outputs for every column a row number of a matrix in which interleave addresses are allocated;
memory address generating means for generating a memory address based on the row number output from said row counter;
address offset value calculating means for referencing a row transposition pattern value corresponding to the row number output from said row counter, multiplying the referenced row transposition pattern value by the number of columns of said matrix and thereby calculating an address offset value; and
adding means for referencing the column transposition pattern value corresponding to the memory address generated by said memory address generating means, adding up the referenced column transposition pattern value and said address offset value and thereby generating an interleave address.

**7.** A turbo coding apparatus equipped with first convolutional coding means for carrying out organic convolutional coding on an information string, an interleaver provided with an interleave address generation apparatus and second convolutional coding means for carrying out convolutional coding on the information string whose data sequence has been rearranged by said interleaver, said interleave address generation apparatus comprising:

a row counter that outputs for every column a row number of a matrix in which interleave addresses are allocated;
memory address generating means for generating a memory address based on the row number output from said row counter;
address offset value calculating means for referencing a row transposition pattern value corresponding to the row number output from said row counter, multiplying the referenced row transposition pattern value by the number of columns of said matrix and thereby calculating an address offset value; and
adding means for referencing the column transposition pattern value corresponding to the memory address generated by said memory address generating means, adding up the referenced column transposition pattern value and said address offset value and thereby generating an interleave address.

**8.** A turbo decoding apparatus comprising:

first decoding means for carrying out soft decoding on an information string;
an interleaver for rearranging the data sequence of the decoding result of said first decoding means;
second decoding means for carrying out soft output decoding on the code string whose data sequence has been rearranged by said interleaver; and
a deinterleaver for rearranging the data sequence of the decoding result of said second decoding means, wherein said interleaver and said deinterleaver are equipped with an interleave address generation apparatus, said interleave address generation apparatus comprising:

a row counter that outputs for every column a row number of a matrix in which interleave addresses are allocated;
memory address generating means for generating a memory address based on the row number output from said row counter;
address offset value calculating means for referencing a row transposition pattern value corresponding to the row number output from said row counter, multiplying the referenced row transposition pattern value by the number of columns of said matrix and thereby calculating an address offset value; and
adding means for referencing the column transposition pattern value corresponding to the memory address generated by said memory address generating means, adding up the referenced column transposition pattern value and said address offset value and thereby generating an interleave address.

9. A mobile station apparatus comprising:

a turbo coding apparatus equipped with first convolutional coding means for carrying out organic convolutional coding on an information string, an interleaver equipped with an interleave address generation apparatus and second convolutional coding means for carrying out convolutional coding on an information string whose data sequence has been rearranged by said interleaver; and
a turbo decoding apparatus equipped with first decoding means for carrying out soft output decoding on a reception string, an interleaver for rearranging the data sequence of the decoding result in said first decoding means according to interleave addresses generated by said interleave address generation apparatus, second decoding means for carrying out soft output decoding on the code string whose data sequence has been rearranged by said interleaver and a deinterleaver for rearranging the data sequence of the decoding result in said second decoding means according to interleave addresses generated by said interleave address generation apparatus.

10. A base station apparatus comprising:

a turbo coding apparatus equipped with first convolutional coding means for carrying out organic convolutional coding on an information string, an interleaver equipped with an interleave address generation apparatus and second convolutional coding means for carrying out convolutional coding on an information string whose data sequence has been rearranged by said interleaver; and
a turbo decoding apparatus equipped with first decoding means for carrying out soft output decoding on a reception string, an interleaver for rearranging the data sequence of the decoding result in said first decoding means according to interleave addresses generated by said interleave address generation apparatus, second decoding means for carrying out soft output decoding on the code string whose data sequence has been rearranged by said interleaver and a deinterleaver for rearranging the data sequence of the decoding result in said second decoding means according to interleave addresses generated by said interleave address generation apparatus.

11. An interleave address generation method comprising:

a step of generating memory addresses based on a row number of a matrix in which interleave addresses are allocated;
a step of calculating an address offset value by multiplying a row transposition pattern value corresponding to said row number by the number of columns of said matrix; and
a step of adding up the column transposition pattern value corresponding to the memory address and said address offset value to generate an interleave address.

[FIRST STAGE]
DETERMINE BLOCK SIZE ROW COUNT R AND COLUMN COUNT C

$R$ $C$

[SECOND STAGE]
DETERMINE COLUMN TRANSPOSITION PATTERN FOR EVERY ROW

$\{C(i)\}$ | C(0) | C(1) | C(2) | ..... | C(P-2) | 1

$P(0)=1$

2-1: | C(0) | C(1) | C(2) | C(3) | ..... |
FIRST ROW

$P(1)=7$

2-2: | C(0) | C(7) | C(14) | C(21) | ..... |
SECOND ROW

$P(2)=11$

2-3: | C(0) | C(11) | C(22) | C(33) | ..... |
THIRD ROW

$P(R-1)=S$

2-(R-1): | C(0) | C(S) | C(2S) | C(3S) | ..... |

WHEN C=p

(A-5)

3-1:
| C(0) | C(1) | C(2) | C(3) | ... | 0 |
| C(0) | C(7) | C(14) | C(21) | ... | 0 |
| C(0) | C(11) | C(22) | C(33) | ... | 0 |
| . | . | . | . |  | . |
| C(0) | C(S) | C(2S) | C(3S) | ... | 0 |

WHEN C=p+1

(B-5)

3-2:
| C(0) | C(1) | C(2) | C(3) | ... | 0 | P |
| C(0) | C(7) | C(14) | C(21) | ... | 0 | P |
| C(0) | C(11) | C(22) | C(33) | ... | 0 | P |
| . | . | . | . |  | . | . |
| C(0) | C(S) | C(2S) | C(3S) | ... | 0 | P |

WHEN C=p-1

(C-5)

3-3:
| C(0) | C(1) | C(2) | C(3) | ... |
| C(0) | C(7) | C(14) | C(21) | ... |
| C(0) | C(11) | C(22) | C(33) | ... |
| . | . | . | . |  |
| C(0) | C(S) | C(2S) | C(3S) | ... |

[THIRD STAGE]
CARRY OUT COLUMN TRANSPOSITION FOR EVERY ROW AND READ IN COLUMN DIRECTION

4:
| P(0)TH ROW |
| P(1)TH ROW |
| P(2)TH ROW |
| . |
| P(R-1)TH ROW |

GENERATION OF INTERLEAVE PATTERN

FIG. 1

22

EP 1 187 339 A1

WRITE →

| A 0 | A 1 | A 2 | A 3 | A 4 | A 5 | A 6 |
|-----|-----|-----|-----|-----|-----|-----|
| A 7 | A 8 | A 9 | A10 | A11 | A12 | A13 |
| A14 | A15 | A16 | A17 | A18 | A19 | A20 |

⇓ COLUMN TRANSPOSITION PATTERN

| A 0 | A 5 | A 3 | A 1 | A 6 | A 4 | A 2 |
|-----|-----|-----|-----|-----|-----|-----|
| A 7 | A10 | A13 | A 9 | A12 | A 8 | A11 |
| A14 | A15 | A16 | A17 | A18 | A19 | A20 |

⇓ ROW TRANSPOSITION PATTERN

READ ↓

| A14 | A15 | A16 | A17 | A18 | A19 | A20 |
|-----|-----|-----|-----|-----|-----|-----|
| A 7 | A10 | A13 | A 9 | A12 | A 8 | A11 |
| A 0 | A 5 | A 3 | A 1 | A 6 | A 4 | A 2 |

FIG. 2

EP 1 187 339 A1

[FIRST STAGE]
DETERMINE BLOCK SIZE ROW COUNT R AND
COLUMN COUNT C

C

R

[SECOND STAGE]
DETERMINE COLUMN
TRANSPOSITION PATTERN FOR
EVERY ROW

{C(i)}  | C(0) | C(1) | C(2) | · · · · · | C(P-2) |  9

P(0)=19

| 0 | 11 | 37 | 31 | · · · · · |
10-1    FIRST ROW

P(1)=67          · · · ·          P(19)=1

| 0 | 13 | 36 | 40 | · · · · · |
10-2    SECOND ROW

P(2)=23

| 0 | 32 | 28 | 2 | · · · · · |          · · · ·          | 0 | 34 | 5 | 50 | · · · · · |
10-3    THIRD ROW                                    10-19

WHEN C=p-1

| {C(i)} | C(0)-1=0 | C(19)-1=11 | C(38)-1=37 | C(5)-1=31 | · · · · · · · · · | C(33)-1=30 |  11 |
| {C(i)} | C(0)-1=0 | C(15)-1=13 | C(30)-1=36 | C(45)-1=40 | · · · · · · · · · | C(37)-1=18 |
| {C(i)} | C(0)-1=0 | C(23)-1=32 | C(46)-1=28 | C(17)-1=2 | · · · · · · · · · | C(29)-1=44 |
|        | · | · | · | · | · | · |
| {C(i)} | C(0)-1=0 | C(1)-1=1 | C(2)-1=3 | C(3)-1=7 | · · · · · · · · · | C(51)-1=26 |

[THIRD STAGE]
CARRY OUT COLUMN
TRANSPOSITION FOR EVERY
ROW AND READ IN COLUMN
DIRECTION

| P(19)TH ROW |
| P(9)TH ROW |  12
| P(14)TH ROW |
| · |
| · |
| P(11)TH ROW |

GENERATION OF INTERLEAVE PATTERN

FIG. 3

| A0 | A1 | A2 | A3 | ····· | A51 |
|------|------|------|------|------|------|
| A52 | A53 | A54 | A55 | ····· | A103 |
| A104 | A105 | A106 | A107 | ····· | A155 |
| A156 | A157 | A158 | A159 | ····· | A207 |
| A208 | A209 | A210 | A211 | ····· | A259 |
| A260 | A261 | A262 | A263 | ····· | A311 |
| A312 | A313 | A314 | A315 | ····· | A363 |
| A364 | A365 | A366 | A367 | ····· | A415 |
| A416 | A417 | A418 | A419 | ····· | A467 |
| A468 | A469 | A470 | A471 | ····· | A519 |
| A520 | A521 | A522 | A523 | ····· | A571 |
| A572 | A573 | A574 | A575 | ····· | A623 |
| A624 | A625 | A626 | A627 | ····· | A675 |
| A676 | A677 | A678 | A679 | ····· | A727 |
| A728 | A729 | A730 | A731 | ····· | A779 |
| A780 | A781 | A782 | A783 | ····· | A831 |
| A832 | A833 | A834 | A835 | ····· | A883 |
| A884 | A885 | A886 | A887 | ····· | A935 |
| A936 | A937 | A938 | A939 | ····· | A987 |
| A988 | A989 | A990 | A991 | ····· | A1039 |

FIG. 4

| A0 | A11 | A37 | A31 | · · · · · | A30 |
|------|------|------|------|------|------|
| A52 | A66 | A88 | A92 | · · · · · | A70 |
| A104 | A136 | A132 | A106 | · · · · · | A148 |
| A156 | A190 | A161 | A206 | · · · · · | A205 |
| A208 | A210 | A216 | A234 | · · · · · | A225 |
| A260 | A304 | A270 | A277 | · · · · · | A292 |
| A312 | A359 | A336 | A345 | · · · · · | A332 |
| A364 | A384 | A380 | A402 | · · · · · | A411 |
| A416 | A420 | A440 | A434 | · · · · · | A447 |
| A468 | A490 | A474 | A515 | · · · · · | A508 |
| A520 | A569 | A528 | A545 | · · · · · | A554 |
| A572 | A592 | A588 | A610 | · · · · · | A619 |
| A624 | A642 | A666 | A645 | · · · · · | A637 |
| A676 | A677 | A679 | A683 | · · · · · | A702 |
| A728 | A761 | A770 | A758 | · · · · · | A766 |
| A780 | A830 | A783 | A822 | · · · · · | A805 |
| A832 | A843 | A869 | A863 | · · · · · | A862 |
| A884 | A905 | A890 | A931 | · · · · · | A924 |
| A936 | A974 | A972 | A947 | · · · · · | A969 |
| A988 | A989 | A991 | A995 | · · · · · | A1014 |

FIG. 5

| | | | | | |
|---|---|---|---|---|---|
| A988 | A989 | A991 | A995 | · · · · · | A1014 |
| A468 | A490 | A474 | A515 | · · · · · | A508 |
| A728 | A761 | A770 | A758 | · · · · · | A766 |
| A208 | A210 | A216 | A234 | · · · · · | A225 |
| A0 | A11 | A37 | A31 | · · · · · | A30 |
| A104 | A136 | A132 | A106 | · · · · · | A148 |
| A260 | A304 | A270 | A277 | · · · · · | A292 |
| A364 | A384 | A380 | A402 | · · · · · | A411 |
| A624 | A642 | A666 | A645 | · · · · · | A637 |
| A936 | A974 | A972 | A947 | · · · · · | A969 |
| A520 | A569 | A528 | A545 | · · · · · | A554 |
| A416 | A420 | A440 | A434 | · · · · · | A447 |
| A676 | A677 | A679 | A683 | · · · · · | A702 |
| A884 | A905 | A890 | A931 | · · · · · | A924 |
| A156 | A190 | A161 | A206 | · · · · · | A205 |
| A52 | A66 | A88 | A92 | · · · · · | A70 |
| A832 | A843 | A869 | A863 | · · · · · | A862 |
| A312 | A358 | A336 | A345 | · · · · · | A332 |
| A780 | A830 | A783 | A822 | · · · · · | A805 |
| A572 | A592 | A588 | A610 | · · · · · | A619 |

FIG. 6

FIG. 7

START

ST205

$i=0$ — YES

NO

ST201

$i=0$ — YES

NO

ST206

$f(j)=0$

ST202

$Q=q(j)$

ST203

$Q=0$

ST207

$f_i(j)=Ptr_{i-1}(j)$

ST204

$Q+f_i(j) \leqq P-1$ — NO

YES

ST208

$Ptr_i(j)=Q+f_i(j)$

ST209

$Ptr_i(j) = Q+f_i(j)-(P-1)$

END

FIG. 8

| A0 | A1 | A2 | A3 | · · · · · | A51 |
|------|------|------|------|-----------|------|
| A52 | A53 | A54 | A55 | · · · · · | A103 |
| A104 | A105 | A106 | A107 | · · · · · | A155 |
| A156 | A157 | A158 | A159 | · · · · · | A207 |
| A208 | A209 | A210 | A211 | · · · · · | A259 |
| A260 | A261 | A262 | A263 | · · · · · | A311 |
| A312 | A313 | A314 | A315 | · · · · · | A363 |
| A364 | A365 | A366 | A367 | · · · · · | A415 |
| A416 | A417 | A418 | A419 | · · · · · | A467 |
| A468 | A469 | A470 | A471 | · · · · · | A519 |
| A520 | A521 | A522 | A523 | · · · · · | A571 |
| A572 | A573 | A574 | A575 | · · · · · | A623 |
| A624 | A625 | A626 | A627 | · · · · · | A675 |
| A676 | A677 | A678 | A679 | · · · · · | A727 |
| A728 | A729 | A730 | A731 | · · · · · | A779 |
| A780 | A781 | A782 | A783 | · · · · · | A831 |
| A832 | A833 | A834 | A835 | · · · · · | A883 |
| A884 | A885 | A886 | A887 | · · · · · | A935 |
| A936 | A937 | A938 | A939 | · · · · · | A987 |
| A988 | A989 | A990 | A991 | · · · · · | A1039 |

FIG. 9

| A988 | A989 | A991 | A995 | · · · · · | A1014 |
|------|------|------|------|-----------|-------|
| A468 | A490 | A474 | A515 | · · · · · | A508 |
| A728 | A761 | A770 | A758 | · · · · · | A766 |
| A208 | A210 | A216 | A234 | · · · · · | A225 |
| A0 | A11 | A37 | A31 | · · · · · | A30 |
| A104 | A136 | A132 | A106 | · · · · · | A148 |
| A260 | A304 | A270 | A277 | · · · · · | A292 |
| A364 | A384 | A380 | A402 | · · · · · | A411 |
| A624 | A642 | A666 | A645 | · · · · · | A637 |
| A936 | A974 | A972 | A947 | · · · · · | A969 |
| A520 | A569 | A528 | A545 | · · · · · | A554 |
| A416 | A420 | A440 | A434 | · · · · · | A447 |
| A676 | A677 | A679 | A683 | · · · · · | A702 |
| A884 | A905 | A890 | A931 | · · · · · | A924 |
| A156 | A190 | A161 | A206 | · · · · · | A205 |
| A52 | A66 | A88 | A92 | · · · · · | A70 |
| A832 | A843 | A869 | A863 | · · · · · | A862 |
| A312 | A359 | A336 | A345 | · · · · · | A332 |
| A780 | A830 | A783 | A822 | · · · · · | A805 |
| A572 | A592 | A588 | A610 | · · · · · | A619 |

FIG. 10

40 : TURBO CODING APPARATUS

FIG. 11

50 : TURBO DECODING APPARATUS

51 SOFT OUTPUT DECODER

52 INTERLEAVER

53 SOFT OUTPUT DECODER

54 DEINTERLEAVER

RECEPTION STRING

ADVANCE INFORMATION

INFORMATION STRING

FIG. 12

60 : MOBILE STATION APPARATUS

61 : ANTENNA

66 : DECODING PROCESSING SECTION

68

70 : SPEAKER

62 RECEPTION SECTION

64 DEMODULATION SECTION

66A DEINTERLEAVE CIRCUIT

66B RATE MATCHING CIRCUIT

66C ERROR CORRECTING /DECODING CIRCUIT

VOICE CODEC SECTION

67 : CODING PROCESSING SECTION

71 : MICROPHONE

63 TRANSMISSION SECTION

65 MODULATION SECTION

67A INTERLEAVE CIRCUIT

67B RATE MATCHING CIRCUIT

67C ERROR CORRECTING /CODING CIRCUIT

69 DATA INPUT/ OUTPUT SECTION

EP 1 187 339 A1

FIG. 13

## INTERNATIONAL SEARCH REPORT

| | International application No. |
|---|---|
| | PCT/JP01/02146 |

A. CLASSIFICATION OF SUBJECT MATTER
Int.Cl⁷ H03M13/27

According to International Patent Classification (IPC) or to both national classification and IPC

B. FIELDS SEARCHED

Minimum documentation searched (classification system followed by classification symbols)
Int.Cl⁷ H03M13/27

Documentation searched other than minimum documentation to the extent that such documents are included in the fields searched

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,X | JP, 2000-209103, A (NEC Corporation), 28 July, 2000 (28.07.00), Figs. 4, 5, 7, 9, 10 & EP, 1020996, A1 | 1-11 |
| X | JP, 1-213037, A (Victor Company of Japan, Limited), 25 August, 1989 (25.08.89), Fig. 1 (Family: none) | ' 1-11 |
| X | WO, 99/25069, A (NTT Ido Tsushinmo K.K.), 20 May, 1999 (20.05.99), abstract & EP, 952673, A1 & CN, 1246991, A | 7-10 |
| P,X | JP, 2000-353965, A (NTT Docomo K.K.), 19 December, 2000 (19.12.00), abstract & EP, 1030455, A2 & AU, 200017603, A & CA, 2298919, A & CN, 1274202, A | 7-10 |
| P,X | JP, 2001-53624, A (Hitachi, Ltd.), 23 February, 2001 (23.02.01), | 7-10 |

☒ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 23 May, 2001 (23.05.01) | 05 June, 2001 (05.06.01) |

| Name and mailing address of the ISA/ Japanese Patent Office | Authorized officer |
|---|---|
| Facsimile No. | Telephone No. |

Form PCT/ISA/210 (second sheet) (July 1992)

## INTERNATIONAL SEARCH REPORT

| International application No. |
| --- |
| PCT/JP01/02146 |

C (Continuation).   DOCUMENTS CONSIDERED TO BE RELEVANT

| Category* | Citation of document, with indication, where appropriate, of the relevant passages | Relevant to claim No. |
| --- | --- | --- |
| | abstract   (Family: none) | |
| P,X | JP, 2001-60878, A (Sony Corporation),<br>06 March, 2001 (06.03.01),<br>Fig. 11   (Family: none) | 7-10 |
| E,X | JP, 2001-102940, A (Fujitsu Limited),<br>13 April, 2001 (13.04.01),<br>Figs. 15, 16   (Family: none) | 7-10 |
| A | WO, 95/18489, A (ZENITH ELETRONICS CORPORATION),<br>06 July, 1995 (06.07.95),<br>abstract<br>& EP, 737385, A1     & US, 5572532, A<br>& JP, 9-507352, A | 1-11 |
| A | JP, 8-335887, A (Fujitsu Limited),<br>17 December, 1996 (17.12.96),<br>abstract   (Family: none) | 1-11 |
| A | JP, 11-145851, A (NEC Corporation),<br>28 May, 1999 (28.05.99),<br>abstract   (Family: none) | 1-11 |

Form PCT/ISA/210 (continuation of second sheet) (July 1992)